# EUROPEAN PATENT APPLICATION

(11) **EP 4 472 020 A1**
(43) Date of publication of application: **04.12.2024**
(21) Application number: 24175966.1
(22) Date of filing: 15.05.2024
(51) Int. Cl.: H02J 7/00, B60L 58/16, G01R 31/392

(54) **METHODS AND SYSTEMS FOR PREDICTING AND CONTROLLING FUTURE BATTERY PERFORMANCE**

(30) Priority: 16.05.2023 US 202363466806 P; 13.05.2024 US 202418662405
(71) Applicant: Qnovo Inc., Milpitas, CA 95035 (US)
(72) Inventor: CHANG, On K, Milpitas, 95035 (US); KOONS, David Bruce, Milpitas, 95035 (US); BERKOWITZ, Fred, Milpitas, 95035 (US); GHANTOUS, Dania, Milpitas, 95035 (US); HOANG, Khanh, Milpitas, 95035 (US); SUMMY, Dustin, Milpitas, 95035 (US)
(74) Representative: Haseltine Lake Kempner LLP

(57) **Abstract**

Disclosed herein are techniques for predicting and controlling future battery performance. In some embodiments, the techniques may involve collecting a multi-dimensional set of battery parameters associated with a rechargeable battery. The techniques may further involve generating a multi-dimensional set of predicted future state of performance values of the rechargeable battery based on the multi-dimensional set of battery parameters . The techniques may further involve performing at least one of (1) identification of a future use pattern of the rechargeable battery based at least in part on the multi-dimensional set of predicted future state of performance values; (2) presentation of an alert indicating a predicted future performance of the rechargeable battery; or (3) identification of a future use pattern of a system to which the rechargeable battery provides power and/or electrical energy based at least in part on the multi-dimensional set of predicted future state of performance values .

## Description

### BACKGROUND

Batteries and battery packs may degrade or develop defects over time and with use. However, it can be difficult to predict future performance of a battery or battery pack, and moreover, to adaptively control use of a battery or battery pack to control future battery performance.

The background description provided herein is for the purposes of generally presenting the context of the disclosure. Work of the presently named inventors, to the extent it is described in this background section, as well as aspects of the description that may not otherwise qualify as prior art at the time of filing, are neither expressly nor impliedly admitted as prior art against the present disclosure.

### SUMMARY

Disclosed herein are techniques for predicting and controlling future battery performance. The techniques may be practiced with a processor-implemented method, a system or apparatus comprising one or more processors, and/or one or more non-transitory processor-readable media.

In some embodiments, the techniques may involve collecting a multi-dimensional set of battery parameters associated with a rechargeable battery. The techniques may further involve generating a multi-dimensional set of predicted future state of performance values of the rechargeable battery based on the multi-dimensional set of battery parameters. The techniques may further involve performing at least one of: (1) identification of a future use pattern of the rechargeable battery based at least in part on the multi-dimensional set of predicted future state of performance values; (2) presentation of an alert indicating a predicted future performance of the rechargeable battery; or (3) identification of a future use pattern of a system to which the rechargeable battery provides power and/or electrical energy based at least in part on the multi-dimensional set of predicted future state of performance values.

In some embodiments, the techniques may involve collecting a multi-dimensional set of battery parameters associated with a rechargeable battery, wherein the multi-dimensional set of battery parameters comprise values of a set of battery parameters at a plurality of timepoints. The techniques may further involve predicting a future performance metric of the rechargeable battery based at least in part on the multi-dimensional set of battery parameters, the future performance metric representing estimates of one or more of: state of power, state of energy, state of capacity, remaining useful life, or state of health at one or more future times.

In some embodiments, the techniques may involve optimizing routes of vehicles. The techniques may involve obtaining, for a given vehicle powered by a rechargeable battery pack, a set of candidate routes from an initial location to a destination. The techniques may further involve determining, for each candidate route, a minimum peak power requirement to traverse the candidate route. The techniques may further involve discarding candidate routes from the set of candidate routes having a minimum peak power requirement exceeding a peak power available from the rechargeable battery pack. The techniques may further involve for each remaining route of the set of candidate routes, determining an amount of energy required to traverse the candidate route. The techniques may further involve selecting a route from the set of candidate routes based on the amount of energy required and an energy available from the rechargeable battery pack.

### BRIEF DESCRIPTION OF THE DRAWINGS

In the course of the descriptions to follow, reference will be made to the attached drawings. These drawings show different aspects of some implementations, and where appropriate, reference numerals illustrating like structures, components, materials and/or elements in different figures are labeled similarly. It is understood that various combinations of the structures, components, and/or elements, other than those specifically shown, are contemplated and are within the scope of the present disclosure.

The present disclosures are neither limited to any single aspect nor embodiment thereof, nor to any combinations and/or permutations of such aspects and/or embodiments. Moreover, each of the aspects of the present disclosures, and/or embodiments thereof, may be employed alone or in combination with one or more of the other aspects of the present disclosures and/or embodiments thereof. For the sake of brevity, certain permutations and combinations are not discussed and/or illustrated separately herein.
**Figure 1** illustrates, in block diagram form a "battery charging system" or a "battery monitoring system" in conjunction with a battery where charging circuitry **112** (including, e.g., a voltage source and/or current source ) responds to control circuitry **116** which receives battery information from monitoring circuitry **114** (including, e.g., a voltmeter and/or a current meter).

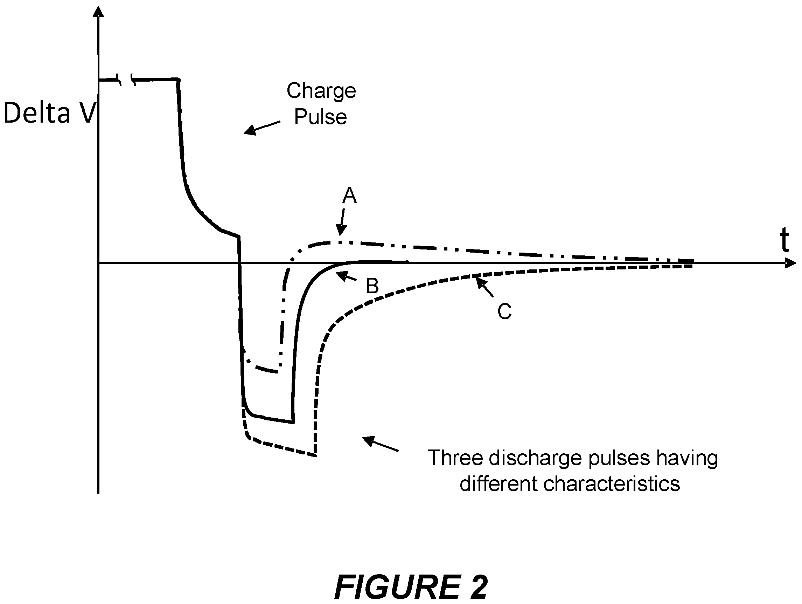

**Figure 2** is an illustration depicting three responses to a charge pulse (which injects charge into the battery) and a discharge pulse (which removes charge from the battery) wherein a first response (A) includes a significant "overshoot" whereby the discharge pulse removed too little charge from the battery, a second response (B) includes no significant "overshoot" or "undershoot" wherein the discharge pulse removes a suitable amount of charge which provides the fastest partial relaxation time of the three responses, and a third response (C) includes a significant "undershoot" whereby the discharge pulse removes too much charge from the battery.
**Figures 3a-3d** illustrate current waveforms of charge signals that may be used to charge a battery.
**Figures 4a****-b** depict current and voltage waveforms resulting from charging a battery using a constant-current constant-voltage (CCCV) technique and an adapted CCCV technique which includes a plurality of constant charge pulses.
**Figures 5A-5E** depict example graphs that illustrate a comparison of various battery parameter values for battery cells having defects relative to healthy battery cells.
**Figure 6** is a graph that illustrates different frequency regimes for electrochemical impedance spectroscopy (EIS).
**Figures 7A** **and** **7B** illustrate various configurations of battery elements in series and/or in parallel in accordance with some embodiments.
**Figure** 8 is a flowchart of an example process for performing at least one action based on predicted future performance of a battery in accordance with some embodiments.
**Figure 9** is a flowchart of an example process for predicting a future performance metric of a battery in accordance with some embodiments.
**Figure 10** is a flowchart of an example process for selecting a route for a vehicle based on characteristics of a battery of the vehicle in accordance with some embodiments.
**Figure 11** is a graph illustrating characteristics of a route to be traversed by a vehicle and of a battery of the vehicle in accordance with some embodiments.
**Figure 12** is a flowchart of an example process for characterizing safety and health characteristics of a battery using collected and stored data in accordance with some embodiments.
**Figure 13** is a schematic diagram of an example system that may be used for characterizing safety and health characteristics of a battery using collected and stored data in accordance with some embodiments.

### DETAILED DESCRIPTION

### Introduction

Disclosed herein are methods and systems for detecting and/or mitigating defects in rechargeable batteries. In some implementations, a defect status for a battery may be determined based on measured battery parameters. In some embodiments, a defect status may be determined based on a rate of change of one or more battery parameters. In some implementations, a defect status may be determined based on a comparison of measured battery parameters to expected values of the given battery parameters, based on a comparison of rates of change of one or more battery parameters to expected rates of change of the one or more battery parameters, based on comparisons of second derivates of battery parameters to expected values of the second derivatives of said battery parameters, etc.

Responsive to determining a defect status, in some implementations, a use pattern of the rechargeable battery may be modified. For example, modification of the use pattern may involve modifying or adapting a charging pattern, a discharge pattern, a storage pattern, a battery temperature, or any combination thereof. Modification of the use pattern may extend battery life, decrease a likelihood of a battery failure, and the like.

In many implementations, battery systems are designed or adapted to capture the necessary parameter values and monitor and/or adaptively charge a rechargeable battery or device.

### Terminology

The term "battery" as used herein refers to one or more galvanic cells (each of which stores energy electrochemically). A battery may be an individual cell and/or a plurality of cells arranged electrically in a series and/or parallel configuration. Although some technical materials describe a battery as including two or more cells, the term "battery" is not so limited in this disclosure. In some implementations, a battery is a single cell or multiple cells connected in series or parallel to provide a desired voltage and/or current rating. Batteries considered herein are typically rechargeable (secondary batteries) and employ an intercalation anode. Intercalation anodes include an intercalation matrix or substrate such as carbon, tin, and/or silicon that is configured to insert or intercalate ions during charge. These ions are typically alkali metal ions (e.g., lithium or sodium ions) or alkaline earth metal ions. In some cases, an anode may be a metal, such as lithium metal, which may be used in some solid-state batteries.

"Battery type" distinguishes classes or groups of batteries from one another. Among the factors that identify a battery type are (i) battery chemistry (e.g., lithium ion (Li⁺) batteries and nickel metal hydride batteries), (ii) battery format (e.g., cylindrical versus prismatic versus pouch) and size (e.g., 18650 versus 21700), (iii) manufacturer identity (e.g., Samsung versus Panasonic), (iv) manufacturing process, and (v) manufacturer process implementation (e.g. lot, plant, and/or site). An example of a battery type is an 18650 format rechargeable lithium-ion battery produced by a particular manufacturer (e.g., Samsung, LG, Sony, etc.) produced in a particular lot using a particular process of the manufacturer. Any one or more of the above factors may be used to define a battery type. Further, the factors may be defined specifically. For example, lithium ion batteries may be divided into types of negative electrodes such as graphite, silicon, tin or tin oxide, or lithium metal.

A "battery element" may be a group of 1 to A (e.g., two, five, twenty, one hundred, one thousand, etc.) cells that are operatively coupled. For example, a battery element may be a single cell. As another example, a battery element may include multiple cells that are operatively coupled, e.g., in parallel.

A "battery pack" is a collection of two or more battery elements electrically connected to one another using series and/or parallel connections. For example, a battery pack may include a plurality of battery elements (e.g., two, five, twenty, one hundred, one thousand, etc.) battery elements coupled in series and/or in parallel. In some implementations, multiple battery elements (e.g., coupled in series) may constitute what is sometimes referred to as "a battery module," and a battery pack may in turn include one or more battery modules electrically connected (e.g., in series and/or in parallel). In some cases, multiple battery packs may be comprised to form what may be referred to as a "superpack." In some embodiments, the battery elements of a battery pack may have substantially identical characteristics such as battery chemistry, capacity, etc. However, in some embodiments, the battery elements of a battery pack may differ with respect to one or more characteristics such as battery chemistry, capacity, etc. A battery pack may include an enclosure housing the constituent batteries. A battery pack may include battery monitoring and/or management circuitry, and/or battery monitoring and/or management software. When a battery pack is monitored, parameters associated with individual battery elements included in the battery pack may be considered in aggregate. As used herein, "aggregate," when used in connection with monitoring battery elements, refers to considering measured or derived parameters from at least a subset of the battery elements of the battery pack. In some implementations, aggregation of parameters of the battery elements may comprise ranking the battery elements, selecting one or more battery elements outside a threshold range with respect to a given parameter, combining (e.g., averaging) parameters associated with two or more battery elements of the pack, applying parameters associated with two or more battery elements of the pack to a function or model that characterizes a current status of the battery pack, or the like.

The term "defect" refers to a condition of a battery. A battery may have one or more defects that cause it to perform below normal expectations or specifications. The reduced performance may manifest as a short cycle life, low current, low discharge voltage, low power generation, low capacity, a short circuit, and the like. In extreme situations, a defect may cause a catastrophic failure or dangerous condition such as a high temperature escalation, leakage of battery components, a fire, and/or an explosion. In some cases, a defect is due to an internal physical condition within the battery. Such defects may have to do with limitations on ion mobility within the electrolyte and/or within the anode or cathode. Defects might also have to do with unusual conditions in the SEI layer of the anode of the cell or a stress fracture in the anode material. In some cases, defects are due to metal (e.g., lithium) plating on the anode. A defect may also be caused by electrolyte depletion or deterioration. In some cases, a defect may be due to manufacturing defects in the design, structure, or materials processing of the battery at the factory (e.g., pinhole defects in the anode, cathode, or separator, or the like). In some cases, a defect may be due to external mechanical damage to the battery during manufacture, assembly, and/or regular use of the battery. It should be understood that the terms "anomaly," "abuse," or "overuse" may be used interchangeably with the word "defect."

As used herein, a "defect status" of a battery may refer to an indication of whether or not a defect is present, has been determined to be present, a defect is likely to be present, whether a defect is likely to occur in a given future time window, and/or the degree to which a defect impacts or will impact the battery's health and/or performance (e.g., the battery's state of health) . A "defect status" may additionally or alternatively refer to an indication of a likelihood of a defect for a given battery, where the indication of a likelihood may be a probability of a defect, an indication that a likelihood of a defect exceeds a given defect threshold (e.g., a threshold of 50% probability, a threshold of 70% probability, a threshold of 90% probability, etc.), or the like.

"Metal plating" refers to the electrochemical deposition of metal on an electrode. The process is sometimes referred to as electroplating. In various embodiments, metal plating occurs by electrochemical reduction of metal ions on a negative electrode (anode during charge). Often metal plating occurs as a result of charging a battery in a regime where a combination of charging parameters and environmental parameters make plating favorable. For example, metallic lithium may inadvertently plate on a carbon-based or carbon-silicon-based intercalation electrode during charging of a lithium ion battery which can lead to dendrites.

"Use pattern" refers to a manner by which a battery is operated over time, typically over multiple cycles or multiple days, weeks, months, or years. A battery's use pattern may be divided into a charge use pattern and a discharge use pattern. Examples of features that may contribute to a battery's use pattern include charge rate, discharge rate, charge profile, and discharge profile. Further examples of battery use pattern features include depth of discharge, capacity, constant current (charge) characteristics, constant voltage (charge) characteristics, voltage and/or current cutoffs during charge, temperature profiles, and/or various environmental operating conditions. Examples of additional use pattern features include dynamic discharge current limits, power limits and/or energy limits, limits on temperature changes, and/or limits on use duration. Use pattern features may be provided as an average value of any such feature, a maximum value of any such feature, a minimum value of any such feature, and the like. Such values may be determined over multiple cycles or a period of use.

"Battery Control Logic" refers to the control algorithms and/or rules that are used for determining charging parameters (for example, the amplitude, width, and frequency of charge and discharge pulses) in the charge process. In some embodiments, the algorithms or rules are chosen to improve or balance a battery's cycle life and/or charge speed. In some embodiments, the algorithms or rules are chosen to reduce, eliminate, or mitigate battery defects. In some embodiments, algorithms or rules may isolate defective or failing cells. Battery control logic may make use of state of health (SOH) information and/or battery feedback measurements that may include the state of charge (SOC), temperature, voltage, current, and the voltage response shape due to charging and discharging cycles. In certain embodiments, battery control logic is implemented as executable instructions or code stored in hardware (e.g., any of various forms of memory), firmware, or software. The battery control logic may also be considered to include one or more processors configured or designed to execute the instructions or code, particularly when such processors are directly linked to the memory or other storage providing the instructions or code. Unless otherwise stated, the terms battery control circuitry and control circuitry are equivalent to battery control logic. Note that battery control logic may be physically co-located with the battery, or, may be remotely located with wireless or wired connectivity.

A "charge signal" refers to the electrical current (e.g., the current waveform) that passes through the terminals of a battery as a result of circuitry configured to apply charge (a charging signal) or remove charge (a discharging signal) from a battery. A charging or recharging sequence, operation, process, or cycle may include one or more charge signals, which, in total, inject or apply charge into the battery and, optionally, one or more discharge signals (e.g., discharge signals), which, in total, remove charge from the battery. A charging signal may contain one or more charge pulses, discharge pulses and rest periods. The pulses may be any shape (for example, rectangular, triangle, sinusoidal or square). In some cases, a charge pulse has a temporal duration of between about 1 ms to about 500 ms. In some cases, a charge pulse may have a temporal duration on the order of seconds or even minutes (e.g., one minute, ten minutes, etc.).

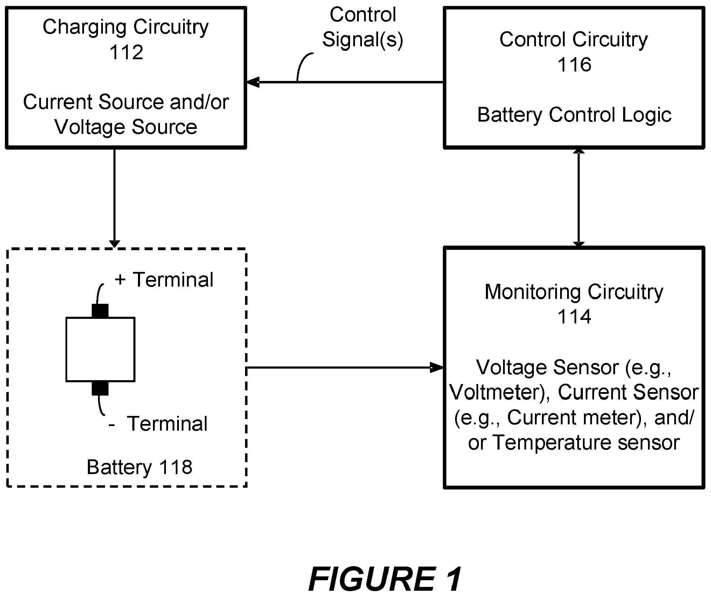

A "battery monitoring system," which may be part of a "battery charging system," is used to monitor a battery and use measured parameter values obtained from the battery (and/or characterizing conditions under which the battery is charged or otherwise operated) to determine whether the battery has plated metal. In various embodiments, the monitoring system uses a battery model to determine whether the battery has plated metal. **Figure 1** depicts in block form a battery charging system that includes charging circuitry **112** that responds to control circuitry **116** which receives battery information from monitoring circuitry **114.**

The charging circuitry **112** is configured to responsively apply electrical charge to the terminals of a battery **118** via a charge signal. The charging circuitry may include a current source and/or a voltage source to provide the charge signal.

The monitoring circuitry **114** is configured to measure, monitor, sense, detect, and/or sample (for example, on an intermittent, continuous and/or periodic basis) one or more conditions or characteristics of the battery. For example, the monitoring circuitry may measure current applied to the battery, a terminal voltage of the battery, and/or a temperature of the battery. The monitoring circuitry provides data which is representative of the condition or characteristics of the battery to control circuitry. In some embodiments, measurements made by monitoring circuitry may be with respect to individual battery cells, a battery pack, a battery module, or any combination thereof.

The control circuitry **116** (or the battery control logic), using data from monitoring circuitry **114,** calculates, determines and/or assesses one or more battery parameter values which may be representative of conditions and/or states of the battery. In some cases, battery parameters are measured by the monitoring circuitry and provided as an input to a model which returns an expected state or condition of the battery. In some cases, battery control logic may determine or estimates a battery's state of charge (SOC), state of health (SOH), partial relaxation time, overpotential, impedance (real and/or complex), spectral dependence of the impedance, and/or a defect status.

Using the data from the monitoring circuitry (or parameters calculated from the data provided by monitoring circuitry) the control circuitry controls (e.g., adapts or terminates) the charge signal(s) applied to a battery via a charge circuitry. For example, control circuitry may determine adopt changes in charging processes.

"Charge Process" or "charging process" refers to a process in which a battery is charged from a state of less charge to a state of more charge. During a charge process, the battery's state of charge increases. A charge process may be conducted under the control of charging circuitry which may be part of the battery control logic. In certain embodiments, charging circuitry adapts, adjusts and/or controls the amplitude, pulse width, or duty cycle of charging or discharging pulses and/or it adjusts and/or controls the conditions of a constant voltage portion of the charge process. It may perform any of these functions to control or adjust a feature of the battery such as the battery's relaxation time, rate, shape, characteristics of the decay of the terminal voltage of the battery, and propensity to plate metal. For example, as depicted in **Figure 2****,** charging circuitry may adapt, adjust and/or control the amplitude and pulse width of the discharge pulse to reduce or minimize the "overshoot" or "undershoot" of the decay of the terminal voltage of the battery. In some cases, the charging circuitry may control the maximum voltage at the terminals, and/or control the maximum state of charge of the battery.

A "charge cycle" is the process of charging a rechargeable battery and discharging it with a particular load. In some implementations, a charge cycle means charging and discharging an amount of charge that is equivalent to the battery's capacity, but not necessarily by one full charge and one full discharge. For instance, using half the charge of a fully charged battery, recharging it, and then using the same amount of charge again count as one charge cycle. The number of charge cycles to failure indicates how many times a rechargeable battery can undergo the process of complete charging and discharging until failing certain criteria. The number of charge cycles may be used to specify a battery's expected life, which may affect battery life more than the mere passage of time.

A "battery parameter" refers to a metric of the battery that may at least partly characterize the state or health of the battery. Examples of battery parameters include open circuit voltage (OCV), charge pulse voltage (CPV), electrochemical impedance spectroscopy (EIS), temperature, capacity, an amount of stored energy, an amount of stored electrical power, a measured or estimated battery swelling, DC impedance, or the like. Battery parameters may be either directly measured (e.g., OCV, CPV, etc.) or may be indirectly estimated based on other measured parameters (e.g., an estimate of battery swelling). In some cases, a battery parameter may be applicable to a particular time point or battery state, such as a particular SOC. In some cases, a battery parameter may include derivatives with respect to time or other variables such as current.

A "directly measured battery parameter" refers to a battery parameter that is measured directly from the battery, such as an OCV, a CPV, a temperature, etc.

A "derived battery parameter" refers to a battery parameter that is determined (e.g., using a model, an algorithm, a mathematical function, etc.) from directly measured battery parameters. One example is an estimate of battery swelling. Another example is a rate of change of a particular battery parameter as a function of time, such as a rate of change in CPV as a function of time. The rate of change of a parameter may be specific to a particular SOC.

It should be understood that, in some cases, a change in a battery parameter may be inferred from adaptive changes applied by a closed loop system to keep the battery parameter within a certain range. By way of example, a closed loop system may adapt charging voltage and/or charging current to keep a particular battery parameter within a certain range. The change in the battery parameter may then be inferred based on changes applied by the closed loop system to drive the battery parameter to stay in the given range.

An "expected value" of battery parameter is a value that is expected based on a particular use pattern and/or a particular state of a battery under consideration. For example, an expected value of a battery's open circuit voltage may be an open circuit voltage expected of a battery based on that battery's current state of health, state of charge, etc. If a battery exhibits a deviation from its expected value, it may be assumed that the battery exhibits a defect or is likely to exhibit such defect. An expected value of a battery parameter may be determined using any or many possible techniques. In some embodiments, an expected value of a battery parameter is generated using a model of battery behavior. In some embodiments, an expected value of a battery parameter is generated using empirical data collected from batteries of a similar type and/or a similar state.

"Capacity" or nominal capacity refers to the total Amp-hours available when the battery is discharged at a certain discharge current (which may be specified as a C-rate) from 100 percent state-of-charge to a defined cut-off voltage that may be defined as zero percent state-of-charge. A battery's capacity may change over multiple charge cycles. In conventional batteries, it is not uncommon for the battery's capacity to decrease or "fade" over multiple cycles.

The term "capacity fade" refers to reduction of battery capacity over time or charge cycles. It may be based on a maximum of the battery capacity or other reference values of battery capacity (e.g., 85% of initial maximum capacity, capacity at specific terminal voltage, etc.)

Terminal voltage is the voltage between the battery terminals. Terminal voltage may vary with state of charge and discharge or charge current. The terminal voltage may be measured with or without current flowing through a load. In the latter case, the terminal voltage is an open circuit voltage.

"State of charge" (SOC) may refer to the fraction of the battery's current capacity that is charged. SOC may be used to characterize how far a battery in use has progressed between a fully charged state and a discharged state. State of charge may be calculated using coulombic integration to determine the change in battery capacity over time or charge cycles. In some implementations, the SOC may be a battery parameter that serves as a reference point that may be utilized from cycle-to-cycle such that other battery parameters may be compared at a fixed SOC across multiple cycles. "State of energy" (SOE) refers to the available energy of the battery at its current state. SOE may be determined based on the present SOC of the battery and the state of health (described below) of the battery. In some cases, a future SOE of the battery may be predicted. "State of power" (SOP) refers to the available power of the battery at its current state. SOP may be determined based on the present SOC of the battery and the state of health of the battery. In some cases, a future SOP of the battery may be predicted. Note that SOC, SOE, and SOP may all be considered examples of battery parameters which may be derived from measured battery parameters, determined using various models or calculations, or any combination thereof.

The "state of health" (SOH) of a battery is a parameter that characterizes the "age" of the battery and/or ability of the battery to hold charge, for example, relative to a given time in operation (for example, the initial time in operation). The SOH of a battery provides information to estimate, calculate, measure, and/or determine other battery parameters such as the ability of a battery to hold a charge. The voltage at the terminals of the battery at a given SOC changes as the SOH changes, and hence the voltage curve (voltage versus state of charge) of the battery shifts as it ages and its SOH deteriorates. The state of health parameter is further described in US Patent No. 9,121,910, issued September 1, 2015, which is incorporated herein by reference in its entirety. In general, "health," as used herein may refer to normal and/or premature aging, as well as to characterization of precursors that may lead to accelerated aging (e.g., faster than normal aging), failure, and/or catastrophic failure.

An "electronic device" as indicated herein refers to a device that performs any number of tasks or functions electrically and can be powered by a battery. The device may or may not physically include (e.g., enclose or attach) the battery, battery charging system, or control logic described herein. Electronic devices may be portable or fixed. Examples of electronic devices include mobile phones, digital cameras, laptops, portable speakers, battery powered vehicles, systems for storing solar and other home generated electrical energy, and power tools. In some cases, an electronic device may include a cloud server that remotely executes one or more functions, e.g., used to control battery charging.

A "battery model" or simply "model" as used herein represents or predicts a battery functionality, battery parameters, and/or a battery status (e.g., a battery state of health, a defect status, etc.) based on other battery parameters (e.g., temperature, SOC, voltage, current, etc.). In certain embodiments, a model can be used to determine expected values of a given battery parameter in order to compare measured values for a particular battery to expected values.

A model may be applicable to a particular battery type (e.g., a particular battery chemistry, cell dimensions, manufacturing batch, etc.). In some cases, a model may account for the state of health of a battery. For example, if irreversible damages to the battery cell have occurred, a model may reflect the battery's state of health.

A model may use battery functional parameters such as charging voltage, discharging voltage, open circuit voltage, charging current, discharging current, state of charge, and battery temperature as inputs or fixed parameters. In some embodiments, a model may use design parameters such as dimensions, types of materials used, electrolyte properties, etc. In some cases, battery parameters may include first or second derivatives with respect to a variable such as time or current. In some cases, battery parameters may include inferred, computed, or estimated potential values within the individual cell, and/or estimates of the potential of the anode electrode and/or the cathode electrode. In some cases, a model outputs a battery's terminal voltage when it receives current and charge time or state of charge as inputs. In some cases, a model outputs a battery's current when it receives terminal voltage and charge time or state of charge as inputs. A model may include lookup tables, expressions such as regression relationships, neural networks, and the like. In some cases, a model may treat the battery as a combination of one or more resistors and one or more capacitors that may be electrically connected in series, in parallel, or in a combination where some elements are in series and some are in parallel. In some cases, the battery is modeled as a two terminal device and in some cases as a three or more terminal device. A model may relate any two parameters in a linear relationship or a non-linear relationship, or in a generalized transfer function. For example, some models may treat the relationship between charge and voltage as linear, while other models treat the relationship as non-linear.

An "open circuit voltage" (OCV) is the terminal voltage of a battery when it is not under an external load. It is a property of the cell. A closed circuit voltage (CCV) is the battery terminal voltage under load (e.g., during charging of the battery). CCV is affected by OCV, but also depends on the operation of the battery. For example, during constant current charging, a CCV may be calculated as the sum of the OCV and the charging current multiplied by the resistance of the battery. During constant voltage charge, the CCV is equal to the applied voltage.

A "charge pulse voltage" (CPV) is a voltage measurement that may be taken to determine a battery parameter (such as SOC or SOH). In some cases, a CPV measurement may be used by an adaptive charging process. A CPV may be characterized as (i) a peak voltage, measured at the terminals of the battery/cell, which is in response to a charge pulse and/or (ii) a substantial peak voltage (i.e., within 5-10% of the peak voltage), measured at the terminals of the battery/cell, which is in response to a charge pulse."Measuring," "collecting," or "capturing" a parameter as stated herein is a way of obtaining a value of the parameter. For instance, measuring the voltage of a battery can mean using an instrument such as a voltmeter to directly measure the voltage between terminals of the battery. In some contexts, it means obtaining parameter values related to raw measurements of the battery and/or deriving other information about the battery (e.g., partial relaxation, battery swelling, etc.). Raw measurements of a battery may include current, charge passed or coulombs injected into the battery, voltage, and temperature. Note that, CPV incorporates the impedance of the cell/battery and is accordingly an indirect measure of EIS.

A "defect likelihood" refers to a probability that a defect, or a particular type of defect, may occur in the future. In some embodiments, a defect likelihood may apply to a particular time window in the future, which may be specified in time (e.g., in the next month, in the next year, etc.) or in a particular number of future charging cycles (e.g., in the next 100 charging cycles, in the next 1,000 charging cycles, etc.).

A "regime" refers to a portion of a battery use pattern, lifetime, or parameter value range. A regime may recur cycle-by-cycle or over other period tied to battery use. Examples of battery parameter value regimes include ranges of state of charge, open circuit voltage, and internal impedance. A regime may be tied to a portion of a charge process such as a constant current region of charging, a constant voltage region of charging, a particular current step of charging, etc. In some cases, a regime is tied to an internal physical or chemical state of a battery. For example, a particular ion conduction state (e.g., an ion mobility range) may define a regime.

Numeric ranges are inclusive of the numbers defining the range. It is intended that every maximum numerical limitation given throughout this specification includes every lower numerical limitation, as if such lower numerical limitations were expressly written herein. Every minimum numerical limitation given throughout this specification will include every higher numerical limitation, as if such higher numerical limitations were expressly written herein. Every numerical range given throughout this specification will include every narrower numerical range that falls within such broader numerical range, as if such narrower numerical ranges were all expressly written herein.

The headings provided herein are not intended to limit the disclosure.

Unless defined otherwise herein, all technical and scientific terms used herein have the same meaning as commonly understood by one of ordinary skill in the art. Various scientific dictionaries that include the terms included herein are well-known and available to those in the art. Although any methods and materials similar or equivalent to those described herein find use in the practice or testing of the implementations disclosed herein, some methods and materials are described.

As used herein, the singular terms "a," "an," and "the" include the plural reference unless the context clearly indicates otherwise.

The logical connector "or" as used herein is inclusive unless specified otherwise. As such, condition "A or B" is satisfied by "A and B" unless specified otherwise.

### Charging Signals

Adaptive charging as described herein refers to charging processes that make use of feedback related to battery conditions, environmental conditions, user behavior, user preferences, and the like. Using adaptive charging techniques, one or more characteristics of a charge signal may be continuously or periodically adjusted or controlled while charging a battery. For example, adaptive charging may be performed to maintain battery parameter values within a selected range. For example, adaptive charging may keep a battery charge process operating in regime where little or no metal plating occurs or is likely to occur. Adaptive charging parameter values are captured and used to control or adjust a battery's charging process, typically to optimize the battery's cycle life (e.g., by reducing or preventing metal plating on the anode) and/or to optimize charge speed. Various adaptive charging techniques are described in applications assigned to Qnovo Inc. Examples of such patents include US Patent No. 8,638,070, titled "METHOD AND CIRCUITRY TO ADAPTIVELY CHARGE A BATTERY/CELL," issued January 28, 2014; US Patent No. 8,791,669, titled "METHOD AND CIRCUITRY TO ADAPTIVELY CHARGE A BATTERY/CELL," issued July 24, 2014; US Patent No. 9,121,910, titled "METHOD AND CIRCUITRY TO ADAPTIVELY CHARGE A BATTERY/CELL USING THE STATE OF HEALTH THEREOF," issued September 1, 2015; US Patent No. 9,142,994, titled "METHOD AND CIRCUITRY TO ADAPTIVELY CHARGE A BATTERY/CELL," issued September 22, 2015; US Patent No. 9,035,623, titled "MONITOR AND CONTROL CIRCUITRY FOR CHARGING A BATTERY/CELL, AND METHODS OF OPERATING SAME," issued May 19, 2015; and US Patent No. 8,907,631, titled "ADAPTIVE CHARGING TECHNIQUE AND CIRCUITRY FOR A BATTERY/CELL USING MULTIPLE CHARGING CIRCUITS AND TEMPERATURE DATE," which issued December 9, 2014. Each of these patents are incorporated herein by reference in their entireties.

Parameters that may be used for adaptive charging include charge pulse voltage, charge pulse voltage reference, partial relaxation time, overpotential, the state of charge, and the battery's state of health. Other parameters may include estimated or computed values of the potential within the battery, such as the potential at the anode or the cathode. In some cases, ranges of acceptable values of each of these parameters may vary as a function of the state of charge during the charge portion of a battery cycle. The parameters values may also vary from cycle-to-cycle over the battery's life. In some cases, adaptive charging may also make use of the current charging parameters such as the current that is being applied to a battery or the terminal voltage that is applied charging circuitry. To illustrate conventional adaptive charging, **Figure 2** illustrates how a charging process can reduce or minimize the "overshoot" or "undershoot" of the decay of the terminal voltage of the battery by adjusting the amplitude and pulse width of a discharge pulse. When a charge process provides an "overshoot" of the decay of the terminal voltage of the battery relative to partial equilibrium (see discharge pulse A), the control circuitry may instruct charging circuitry to adjust the characteristics of the discharge pulse and increase the amount of charge removed by the discharge pulse. For example, by increasing the amplitude and/or pulse width of the discharge pulse the overshoot may be corrected. When a charge process results in an "undershoot" of the decay of the terminal voltage of the battery relative to partial equilibrium (see discharge pulse C), control circuitry may instruct charging circuitry to decrease the amount of charge removed by the discharge pulse (for example, via decreasing the amplitude and/or pulse width of the discharge pulse). As such, the control circuitry may adjust the characteristics of a discharge pulse (for example, the amplitude, pulse width and/or pulse shape) to control or adjust rate, shape and/or characteristics of the decay of the terminal voltage of the battery.

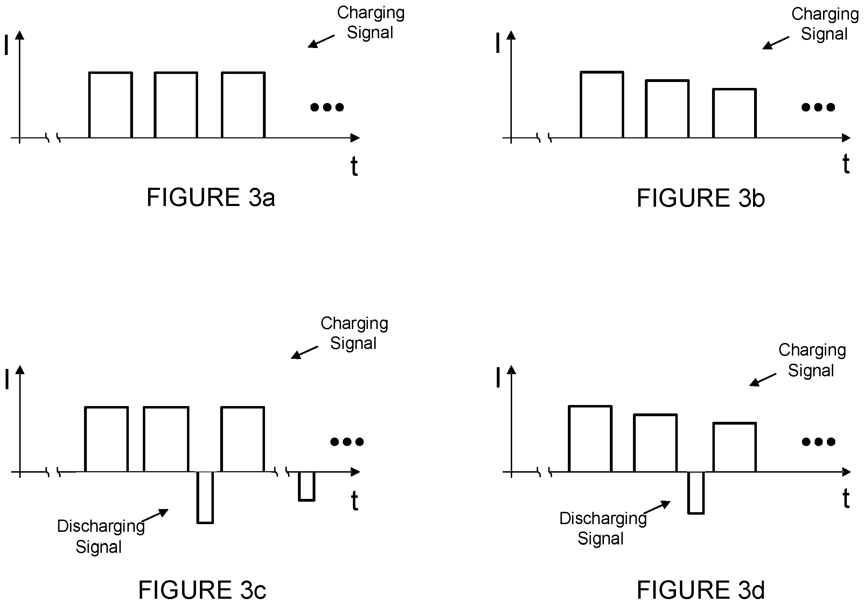

**Figures 3a-3d** illustrate waveforms of charge signals. A charging or recharging sequence, operation, or cycle may include charging signals (which, in total, inject or apply charge into the battery) and discharging signals (which, in total, remove charge from the battery). Charging signals may decrease according to a predetermined rate and/or pattern (for example, asymptotically, linearly or quadratically) as the terminal voltage of the battery increases during a charging or recharging sequence, operation, or cycle (see, e.g., **Figures 3b** and **3d****).** In some cases, a pulse charging sequence or operation may include a constant voltage (CV) phase after a period of pulse charging and/or upon charging the battery/cell to a predetermined state of charge.

Note that, in some implementations, a charging sequence or a charging process may be adapted based on, e.g., detection or determination of a battery defect. For example, in some embodiments, a voltage (e.g., a maximum voltage) may be modified (e.g., lowered) during a CV phase of a charging process. As another example, in some embodiments, a current (e.g., a charging current) may be modified (e.g., lowered) during a constant current (CC) phase of a charging process. In some implementations, a defect may be detected or diagnosed during one charging cycle, and adaptations to the charging process may be implemented in either the same charging cycle and/or subsequent charging cycles. More detailed techniques for modifying charging voltage and/or charging current as part of adaptively modifying a charging process are described in U.S. Patent No. 10,389,156, filed on October 11, 2017, and in U.S. Patent No. 11,237,216, filed on August 15, 2017, each of which are hereby incorporated by reference herein in their entireties for all purposes.

It should be understood that various pulse structures, e.g., of the types illustrated in Figures 2 and 3a-3d (or of those not illustrated herein) may be used to charge a battery and/or to determine characteristics of a battery. The pulse structures illustrated in Figures 2 and 3a-3d are examples of charge pulses and/or discharge pulses, however, other pulse shapes may be used to implement the techniques described herein.

Some or all of the characteristics of the charge and discharge pulses may be programmable and/or controllable. For example, the pulse amplitude, width/duration, and shape may be adjusted. In other examples, the amplitude of the positive and/or negative pulses may vary within the packet, the duration and/or timing of the rest periods may vary within the packet, and/or pulses may be equally or unequally spaced within the packet. The combination of charging pulses, discharging pulses and rest periods may be repetitive, thereby forming a packet that may be repeated. All combinations or permutations of pulse characteristics, periods, packets and signal characteristics and configurations are intended to fall within the scope of the present inventions.

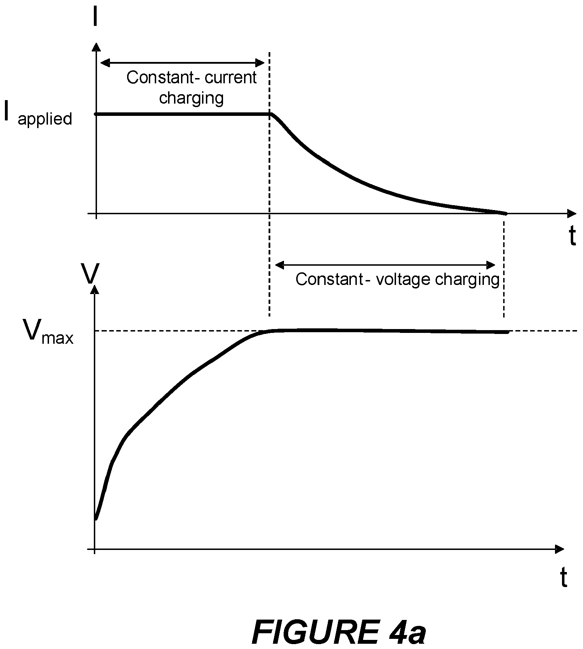

**Figure 4a** illustrates current and voltage of a battery as a function of time illustrating the conventional charging method known as constant-current, constant-voltage (CCCV). When charging a rechargeable battery (e.g., a lithium-ion type rechargeable battery) using CCCV, the charging sequence includes a constant-current (CC) charging mode until the terminal voltage of the battery/cell is at about a maximum amplitude (for example, about 4.2V to 4.5V for certain lithium-ion type rechargeable batteries) at which point the charging sequence changes from the constant-current charging mode to a constant-voltage (CV) charging mode. In the CV mode, a constant voltage is applied to the terminals of the battery. Generally when charging a rechargeable battery using the CCCV technique, the charging circuitry often changes from the CC charging mode to the CV charging mode when the state of charge (SOC) of the battery is at about 60-80%, although in some embodiments, as described herein, a charging circuitry does not enter a CV charging mode until the battery charge is greater than about 90% SOC or greater than about 95% SOC.

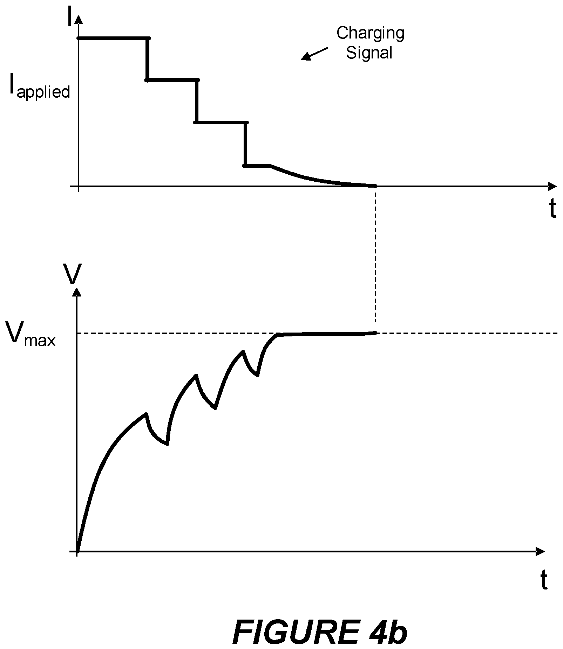

**Figure 4b** illustrates current and voltage of a battery as a function of time illustrating a charging method known as a step-charging technique. A step-charging process of a rechargeable battery (e.g., a lithium-ion type rechargeable battery), employs a multiple step constant-current (CC) charging mode until the terminal voltage of the battery is at about a maximum amplitude (for example, about 4.2V to 4.5V for certain lithium-ion type rechargeable cells) at which point the charging sequence changes from the constant-current charging mode to a constant-voltage (CV) charging mode. As with the CCCV technique depicted in **Figure 4a****,** a constant voltage is applied to the terminals of the battery while in the CV mode.

### Detecting and Mitigating Battery Defects

In some embodiments, a defect status may be determined for a battery. The defect status may be determined by obtaining one or more battery parameters (which may be measured battery parameters and/or derived battery parameters) and determining a rate of change for at least one of the battery parameters. The rate of change of at least one battery parameter may then be compared to an expected rate of change of at least one battery parameter. A defect status, may indicate that a defect has likely already occurred or is likely to occur in a future time window (e.g., in the next week, in the next month, in the next two months, etc.). Note that, as used herein, "likely" may mean having a probability greater than a threshold probability, e.g., with a probability of greater than about 50%, a probability of greater than about 70%, a probability of greater than about 90%, etc. In some implementations, based at least in part on the defect status, a use pattern of the battery, such as a manner in which the battery is charged and/or discharged, may be modified or adapted. Adapting use patterns of the battery may serve to mitigate a defect or a likely defect of the battery.

A battery defect may occur due to battery abuse, battery overuse, and/or a battery anomaly (e.g., a manufacturing anomaly). In some cases, a battery defect may indicate abnormal aging of the battery. Generally, abnormal aging may be recognized without necessarily determining the type of defect that causes the abnormal aging. Further analysis and qualification may be made to determine the type of defect that causes the abnormal aging.

Various types of defects may be detected and/or mitigated using the techniques described herein. In some cases, battery defects may result from an abnormality in one or more internal components of a battery. Such defects may arise from manufacturing anomalies or usage that can lead to limitations in ion mobility within the electrolyte, separator, and/or within the anode and cathode. Defects might also arise from a problem with the SEI layer on the anode of the battery (e.g., in cases of a non-metallic anode). Examples of manufacturing defects include: torn or folded layers, including the separator, anode, or cathode tabs; pin defects; insufficient electrolyte; non-uniform thickness of any structural layer; misaligned layers (e.g., anode versus cathode, anode versus separator, etc.); structural asymmetries in assembly of internal layers; distortions or mechanical stress; mismatched anode and cathode capacities; and mechanical fracture of grains or layers and/or structural materials. Such manufacturing defects may manifest in one or more ways, including: rapid SEI layer growth; stress and mechanical fracture of material grain; loss or decomposition of electrolyte; excess current concentration leading to excess localized temperature rise and/or damage to layers; rise in electrical impedance; changes in the potential distribution within the cells, including the potential at the anode and/or cathode electrodes; degradation of ionic diffusion/transport properties within the anode and/or cathode and across the layers from one electrode to another; and formation or presence of lithium metal plating in the form of thin films or non-uniform dendrites. In some cases, defects may arise from physical damage to the battery (e.g., a dent), environmental damage (e.g., due to high temperatures), and/or electrical damage (e.g., over-voltage). In some cases, defects may arise due to extreme temperatures (either too hot or too cold).

Various battery parameters, which are described below in more detail, may be utilized to detect battery defects. Some of these are directly measured and quantified. Such directly measured parameters may be provided in terms of a magnitude, a polarity or direction (e.g., as a positive or negative voltage or current), and/or a phase difference between signals (e.g., between current and voltage).

In some embodiments, a battery parameter may be an indirectly measured parameter that is derived from directly measured parameters. In some cases, a derived battery parameter represents a change in magnitude, phase, and/or a change in direction of any one of the directly measured parameters. In some cases, a derived battery parameter may represent a spectral change (e.g., based on electrochemical impedance spectroscopy (EIS)). For example, the rate of change of a parameter and/or the change in direction of a parameter may be a derived battery parameter. In other cases, a derived parameter may represent the potential distribution within the cells, at the electrodes, and/or between the electrodes.

Examples of battery parameters include: open circuit voltage (OCV); charge pulse voltage (CPV), which is often an indication of ion diffusion in the anode of the battery; EIS, which is a measure of ion diffusion in the battery materials (e.g., anode, cathode, and/or electrolyte), particularly at low frequencies and is indicative of the dynamics of charge transfer at higher frequencies; overpotential, which is a measure of the cell's departure from equilibrium, itself a measure of the potential distribution within the cell; temperature; capacity; swelling of the battery (which may be measured using various techniques such as those described in US Patent No. 11,079,212 issued August 3, 2021, which is incorporated herein by reference in its entirety); impedance, which may indicate the internal physical condition of a battery and which may be described in the form of complex impedance elements dependent on frequency; SOC, which may itself depend on battery voltage and/or battery health; and loaded circuit voltage (LCV) and current. Loaded circuit voltage refers to the terminal voltage of a battery when a load is connected, and may be measured at a battery cell or element level and/or at a battery pack level Note that battery parameters may be provided as either an absolute magnitude, a direction or polarity, and/or a rate of change. In some cases, each battery parameter may be measured as a function of SOC, as a function of cycle number, as a function of voltage, as a function of time, or any combination thereof.

Note that, in some embodiments, a prior pattern of using a battery may also be used, optionally along with battery parameters, in determining whether a battery defect has occurred or is likely to occur. A battery use pattern may also be used to indicate a likelihood that a defect will occur in the future if a present use pattern continues and/or if a different use pattern is adopted. A battery use pattern may be described or characterized in various ways. Examples of ways in which a battery use pattern may be characterized include: a mode of charging a battery, a mode of storing a battery, a mode of discharging the battery, and the like. Factors such as charge rate, discharge rate, output power and/or energy, depth of charge, depth of discharge, temperature, storage condition, duration of use, etc. may be pertinent parts of a battery's use pattern. These or other factors may be represented as an average, maximum, and/or minimum value.

By way of example, a battery use pattern during charging of the battery may be represented by: values and sequence of current and/or voltage over time that are used to charge the battery; values and sequence of current and/or voltage as a function of SOC of the battery; values and sequence of current and/or voltage as a function of temperature; values and sequence of current and/or voltage as a function of health and/or age of the battery; or any combination thereof.

As another example, a battery use pattern during discharge of the battery may be represented by values and sequence of current and/or voltage as they fluctuate over time during operation of a device powered by the battery. As a more particular example, a battery used on a mobile device to view media content may have a discharge pattern that is different from the discharge pattern of a battery used to accelerate an electric vehicle. Other examples of representations of battery use patterns during discharge of a battery include: discharge dependence on SOC; discharge dependence on temperature (e.g., whether an electric vehicle has a reduced driving range in cold weather); discharge dependence on battery health or age; and discharge dependence on battery design, materials, or manufacturing. As used herein, discharge generally refers to output current, power and/or energy delivered by the battery or a battery pack in a discharge mode to power external elements such as motors, electrical circuits, a home, a utility grid, or the like.

As yet another example, a battery use pattern as it relates to storage of the battery may be dependent on factors associated with the storage, such as whether the battery is plugged in while stored, the temperature of the storage area, whether the battery is connected to other cells in the pack, a duration of storage, or any combination thereof.

In some embodiments, a rate of change of a given battery parameter may be utilized to determine a defect status of a battery. In some implementations, the rate of change of a parameter may be with respect to a particular recurring state of a battery, such as an SOC of the battery. The recurring state may be discrete value (e.g., SOC = 50%) or it may be a bounded region of regime (e.g., SOC is between 20 and 25%). By way of example, a rate of change of an OCV at a particular SOC being greater than expected may indicate a possible defect such as lithium metal plating. As another example, a rate of change of a CPV at a given SOC being greater than expected may indicate a possible defect such as lithium metal plating. Other examples of rates of change include: a rate of change of the state of heath (SOH) of the battery; a rate of change of diffusion; relaxation time; overpotential; estimated electrode potentials; and/or a rate of change of EIS impedance (e.g., real impedance and/or complex impedance) as a function of time.

In some implementations, the recurring state that is used for each reading of a particular battery parameter value may occur over successive battery cycles, assuming that a battery is cycled normally (e.g., it is fully discharged and fully charged from one cycle to the next). Sometimes, however, a battery is not fully charged or discharged but rather turned off and on while being partially charged and then partially discharged. In such cases, the concept of a battery cycle might not be represented, but nevertheless, a battery parameter of interest can be measured repeatedly; for example, each time the battery reaches a defined state (e.g., 50% SOC). As an example, a battery may be discharged from 70% to 30% and charged again repeatedly by a user or by a particular application. This may result from the user's preferences or habits and/or from a battery management protocol that limits the battery to a particular cut off charge level and/or a particular cut off discharge level. Regardless of whether recurring states of charge (for measuring a battery parameter) are encountered on a cycle-by-cycle basis and/or just in response to the battery repeatedly crossing that state of charge in a non-cyclic basis, a particular value of state of charge is repeatedly encountered over time. And regardless of how that state of charge is encountered, each time it is encountered, a battery parameter of interest may be measured so that rate of change of that battery parameter can be determined. The repeated measurements used in determining rate of change may be made over a particular window of occurrences, such as over the last X cycles and/or the last X months or weeks or other period of use.

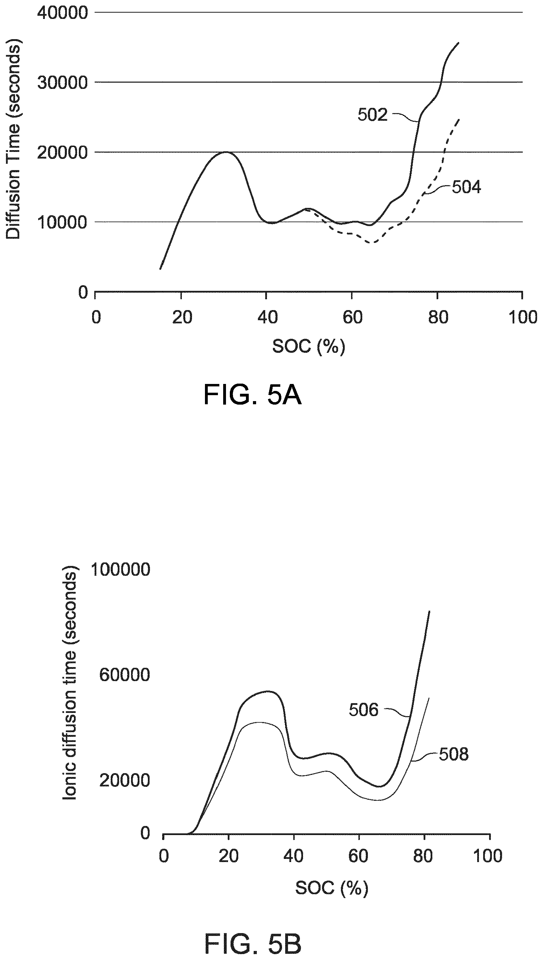

Turning to Figures 5A-5E, example graphs depicting various battery parameter measurements are illustrated in accordance with some embodiments. Figure 5A illustrates diffusion time (in seconds) as a function of SOC for a battery cell exhibiting the presence of one or more defects (e.g., lithium plating) in curve 502 and for a battery cell free of any defects (e.g., free of lithium plating) in curve 504. As illustrated, at a given SOC, a cell with one or more defects may have a higher diffusion time relative to a cell without defects, particularly at higher SOC values (e.g., above 50%, above 60%, above 70%, etc.). Figure 5B illustrates another example of diffusion time as a function of SOC for a battery cell exhibiting the presence of one or more defects (e.g., lithium plating) in curve 506 and for a battery cell free of any defects in curve 508. Note that, similar to what is shown in Figure 5A, at a given SOC, the cell with one or more defects has a higher diffusion time relative to the cell without defects.

Figures 5A and 5B illustrates ionic diffusion values, which may be influenced by ions moving within the electrolyte, across the electrolyte-electrode interface, and within the solid electrode. In some embodiments, a measured diffusion metric may be some composite of diffusion at two or more regions. The regions that contribute to a given diffusion metric may depend on a frequency at which a measurement (e.g., an EIS measurement) is made or derived. It should be noted that diffusion, e.g., ionic diffusion, may be derived from various battery parameter values. These battery parameter values may include CPV, overpotential, relaxation time, partial relaxation time, EIS information, or any combination thereof. When EIS information is used, EIS data obtained from a low-frequency regime (e.g., less than about 10 Hz) may be particularly useful for determining ionic diffusion metrics. More detailed techniques relating to determination of diffusion information, as well as characterization of the underlying phenomena, are described in U.S. Patent No. 11,397,215, filed November 7, 2018, which is hereby incorporated by reference herein in its entirety for all purposes.

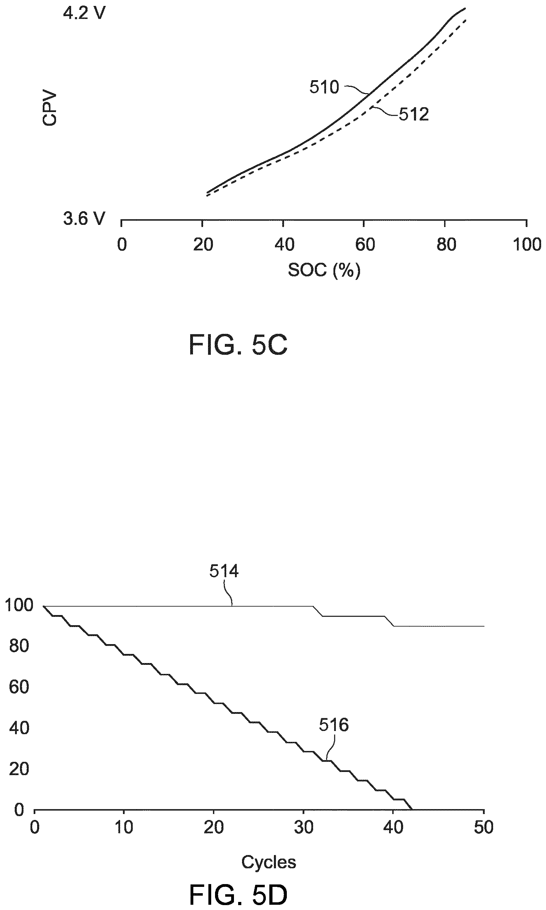

Turning to Figure 5C, a graph that illustrates CPV (in Volts) as a function of SOC is shown for a battery cell having one or more defects in curve 510 and for a battery cell free of any defects in curve 512. As illustrated, at a given SOC, a battery cell having one or more defects may have a higher CPV relative to a battery cell free of any defects. The difference in CPV for a battery cell having defects versus the expected CPV for a battery cell free of defects may be higher at relatively higher SOC values (e.g., above 50%, above 60%, etc.).

Turning to Figure 5D, a graph that illustrates a battery health index as a function of number of battery cycles is shown in accordance with some embodiments. As illustrated by curve 514, for a battery cell free of any defects the battery health index is relative stable over, e.g., 50 charging cycles. In contrast, as illustrated by curve 516, for a battery cell having one or more defects, the battery health index decreases over the multiple charging cycles.

Battery health index may be a metric that is normalized (e.g., to a value between 0 and 100 as shown in Figure 5D). The battery health index may be a composite score that is determined based on multiple battery parameter values, such as CPV, diffusion time, partial relaxation time, overpotential, full relaxation time, DC impedance, EIS quantities (e.g., real impedance and/or complex impedance), temperature, capacity, or any combination thereof. In some implementations, the battery health index may be determined using a mathematical function or a model (e.g., a regression model, or the like), that takes, as inputs, one or more battery parameters (e.g., one, two, three, five, etc. battery parameters) and generates the battery health index as an output. In some embodiments, the battery health index may be determined by employing a function that takes, as inputs, one or more battery parameters and determines the battery health index as an output. The function may be a weighted sum, an exponential function, a polynomial function, utilize the output of a machine learning model, or the like. In one example, a battery health index may be determined as a combination of CPV and diffusion information. In another example, a battery health index may be determined based on high frequency impedance information, which may include real and/or imaginary impedances. In yet another example, in some implementations, a battery health index may be determined based on DC impedance. In some implementations, one or more battery parameter values used to determine a battery health index may be proxy values for a given battery parameter. A proxy value may be a value of a surrogate parameter that is varied to keep a different battery parameter within a given range (or above or below a given threshold) in a closed-loop system during charging and/or discharging. By way of example, current may be modified (e.g., during charging of a battery) to control a DC impedance or an EIS characteristics of the battery, e.g., to force the DC impedance and/or the EIS characteristics to remain within a given range or above or below a predetermined threshold. Continuing with this example, the current values used to control the DC impedance and/or the EIS characteristics may be considered a proxy value, and may in turn by used to determine the battery health index.

Note that, as illustrated in Figure 5D, for a battery cell exhibiting one or more defects, the battery health index may decrease in a substantially linear manner as a function of cycle number. However, in other cases, the decrease in the battery health index may have any other shape, such as a substantially exponential decrease, or the like. As illustrated in Figure 5D, the change in battery health index may have a piecewise shape, as the battery health index may be measured and/or characterized as a function of cycle number. It should be understood that, in some cases, a battery health index score may characterize a health of the battery in a manner that provides more granular and/or predictive information relative to other battery parameters, such as battery capacity. By way of example, in some cases, a battery's capacity may be determined to be substantially normal or as expected for a given type of battery and/or for a battery having a given age, however, the battery health index may be lower than expected. This may indicate degradation in the battery that is not yet visible in the battery capacity metric.

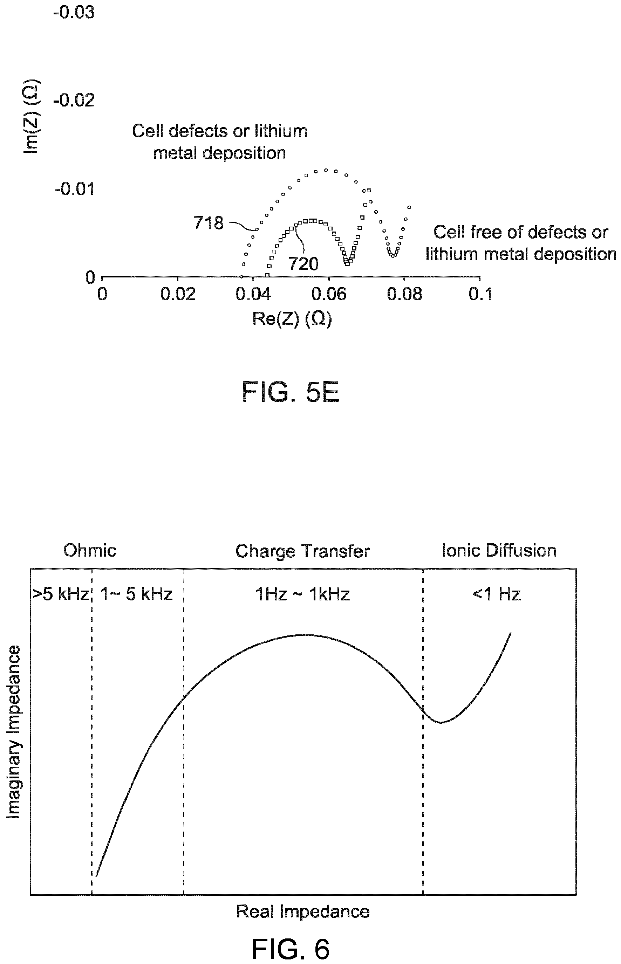

Turning to Figure 5E, a graph that illustrates EIS measurements for a battery cell with defects and without defects is shown in accordance with some implementations. In particular, the graph shown in Figure 5E illustrates imaginary impedance as a function of real impedance for a battery cell with defects in curve 518, and for a battery cell without defects in curve 520. It should be noted EIS measurements may be made in either the time domain or the frequency domain. For example, the EIS measurements depicted in Figure 5E are represented in the frequency domain, where each point represents a different frequency. However, in some cases, EIS measurements may be taken in the time domain (e.g., with different points corresponding to different time points), and may subsequently be converted to the frequency domain. Referring to Figure 6, different frequency bands with respect to EIS represent diffusion at different scales. For example, the high frequency range (e.g., greater than about 1 kHz) represents the ohmic regime. As another example, a middle frequency range (e.g., within a range of about 1 Hz to 1 kHz) represents the charge transfer regime, as illustrated in Figure 6. A low frequency range (e.g., less than about 1 Hz) represents the ionic diffusion regime. The ionic diffusion regime represents diffusion of ions throughout the battery (e.g., from cathode to anode), and represents an average of different types of diffusion (e.g., electrolytic diffusion, solid state diffusion, etc.), as illustrated in Figure 6.

It should be noted that various battery parameters may be derived from EIS measurements. For example, diffusion time, as shown in Figure 5A, may be derived from EIS measurements. In particular, in some cases, a diffusion time may be calculated using a slope of the EIS measurements within the low frequency range (e.g., from points on the right most side of the EIS graph shown in Figure 5E, corresponding to frequencies less than about 1 Hz). CPV is another example of a battery parameter that may be derived from EIS measurements.

The graphs depicted in Figures 5A-5E illustrate comparisons of a given battery parameter for a battery cell having one or more defects versus the expected value of the given battery parameter (e.g., for a battery cell without any defects). In some implementations, comparisons of a measured battery parameter value to an expected battery parameter value may be utilized. Additionally or alternatively, in some implementations, a rate of change of a given battery parameter may be utilized. It should be noted that, in some cases, an absolute value of a particular parameter may indicate present battery health, whereas a rate of change of the same parameter may indicate future safety of the battery. In some cases, rate of change of a particular parameter may be compared at different SOCs. For example, at a first SOC (e.g., 40%), the rate of change of a parameter may be X, whereas at a second SOC (e.g., 70%), the rate of change of the same parameter may be a different value Y. For a particular parameter, predictive accuracy may be dependent on the SOC. In other words, some SOCs may be more sensitive than other SOCs. In some cases, a rate of change of a particular parameter may be compared at other battery states, such as at a particular value or range of: terminal voltage or voltage range, cycle number, temperature, frequency of measurement (e.g., in the case of EIS measurements), or any combination thereof.

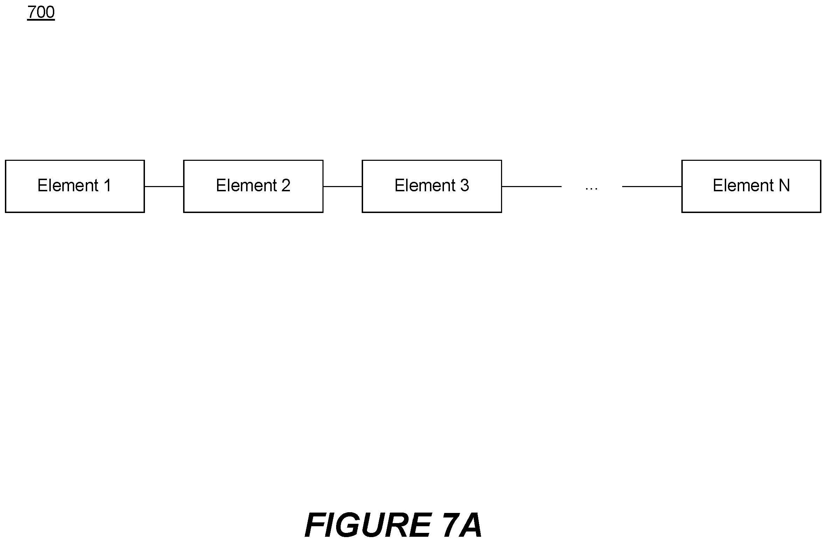

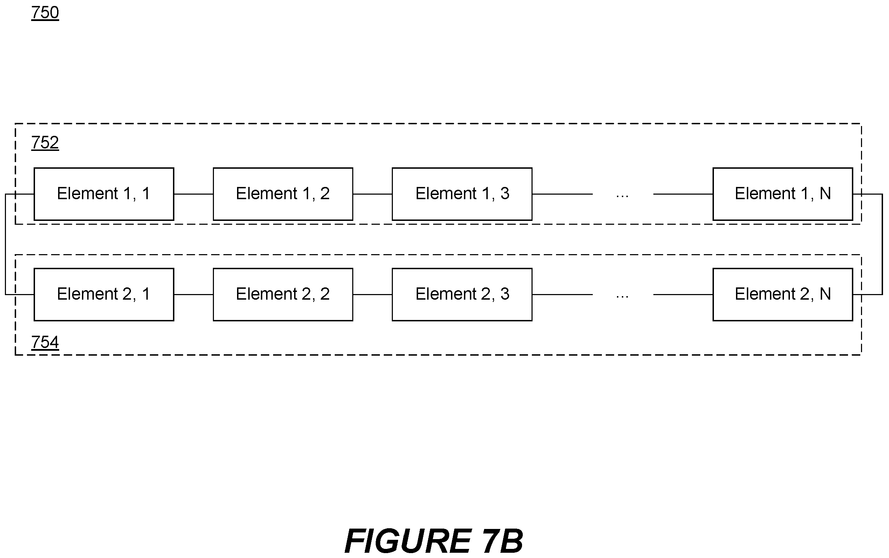

In some implementations, techniques may be implemented to predict future performance of a battery pack. As described above, a battery pack may include multiple (e.g., two, three, at least about twenty, at least about one hundred, at least about one thousand, etc.) battery elements electrically arranged in series and/or in parallel. Figures 7A and 7B illustrate different configurations of battery elements arranged in series and/or in parallel in accordance with some embodiments. For example, Figure 7A illustrates a configuration 700 that includes N battery elements arranged in series. Example values of *N* include five, ten, twenty, fifty, one hundred, one thousand, etc.

Figure 7B illustrates a configuration 750 that includes a first set 752 of battery elements arranged in series, and a second set 754 of battery elements arranged in series. As illustrated in Figure 7B, first set 752 is arranged in parallel with second set 754. Note that, although first set 752 and second set 754 each have the same number of battery elements arranged in series (e.g., N battery elements arranged in series), in some implementations, each set of series battery elements may have differing numbers of battery elements. Additionally, note that although Figure 7B illustrates two sets of battery elements arranged in parallel with each other, in some embodiments, a battery pack may include any suitable number (e.g., two, three, five, at least about ten, at least about fifty, at least about one hundred, etc.) sets of battery elements (or sets of battery elements in series) in parallel with each other.

Disclosed herein are techniques for predicting future performance and health of a battery. Note that, as used herein, a battery may include a single battery cell, a battery pack comprised of multiple cells coupled in series and/or in parallel, or a battery module comprised of multiple battery packs. Based on the predicted future performance, various actions may be performed, such as presenting an alert regarding the future performance, modifying charging and/or discharging processes of the battery, modifying a use pattern of a device to which the battery provides power and/or electrical energy, or the like. In some embodiments, use patterns of the battery and/or the device to which the battery provides power and/or energy may be modified such that the predicted future performance of the battery improves, e.g., toward a target future performance value. In some embodiments, future performance may be predicted at a future time point that is e.g., weeks or months in the future, or is tens to hundreds of charging cycles in the future. By modifying battery or device patterns based on predicted future performance of the battery, battery performance characteristics may effectively be improved during usage of the battery, thereby extending a remaining useful of the battery, increasing state of power (SOP), state of energy (SOE), state of capacity, and/or state of health (SOH) over time, decreasing a likelihood of defects, or the like.

It should be understood that, as used herein, a battery may provide power and/or electrical energy to a device, which may be a vehicle, an energy storage system, an energy charging station (which may be mobile or stationary), a computing device, or the like. Example vehicles include two-wheel vehicles, four-wheel vehicles (e.g., a car, a truck, a commercial delivery truck, etc.), aerial vehicles, a stationary station, a maritime vessel, or the like.

In some embodiments, the techniques described herein can predict a future state of a rechargeable battery (which may include a rechargeable battery pack and/or a rechargeable battery module comprised of multiple battery packs). The future state may include predicted future values of multiple battery parameters. The predicted future values may be in the form of a multi-dimensional set of predicted future performance values. For example, a multi-dimensional set of predicted future performance values may include a first dimension corresponding to predicted performance values at a first future time point (e.g., in an hour, in two hours, in one day, etc.), a second dimension corresponding to predicted future performance values at a second future time point (e.g., in six months, in one year, etc.), etc. A multi-dimensional set of predicted future performance values may include any suitable number of dimensions (e.g., one, two, three, ten, twenty, one hundred, etc.). Although different points of time at which the predictions are applicable is one example of different dimensions, this is merely an example. In some embodiments, a multi-dimensional set of predicted future battery performance values may include an indication of a remaining useful life of the battery, a safety risk associated with the battery, a distance a vehicle powered by the battery can travel using the battery, an indication of a state power (SOP) of the battery, an indication of a state of energy (SOE) of the battery, a state of health (SOH) of the battery, one or more temperatures or temperature gradients associated with the battery, or any combination thereof. Each of these predicted values may be predicted for multiple time points, with each time point corresponding to a dimension of the multi-dimensional set of predicted future values. Note that, in instances in which the battery comprises a battery pack or a battery module, future values may be predicted (at one or more time points) for each battery cell individually (of a battery pack) and/or for each pack individually (of a module). Additionally, it should be noted that a confidence level may be determined for each predicted future performance value. Predictions for time points that are further out in time may have a lower confidence level than those that are sooner in time. In some embodiments, modifications of use patterns of a battery and/or a device to which the battery provides power and/or energy may be determined based at least in part on the confidence level.

The techniques described herein may generate predicted future battery performance values using one or more models. The models may include numeric simulation models, trained machine learning models, regression models, or any combination thereof. The predicted future battery performance values may be determined based on one or more battery parameters, which may be any combination of measured battery parameters or derived battery parameters, as described above. For example, in some embodiments, a set of battery parameters used to determine the predicted future performance values may include any combination of: an open circuit voltage of the rechargeable battery, a loaded circuit voltage of the rechargeable battery, a charge pulse voltage of the rechargeable battery, electrochemical impedance spectroscopy (EIS) information associated with the rechargeable battery (which may include spectroscopic data that include voltage, impedance, and/or current as a function of frequency), an overpotential, an estimate of internal electrode potentials, a capacity of the rechargeable battery, impedance information associated with the rechargeable battery, a current associated with the rechargeable battery, a temperature of the rechargeable battery, a state of charge (SOC) of the rechargeable battery, a state of safety of the rechargeable battery, a state of health (SOH) of the rechargeable battery, derivatives with respect to time of one or more measured battery parameters, or gradients with respect to a spatial region of one or more measured battery parameters. In some implementations, at least one battery parameter may be derived as a result of applying at least one measured battery parameter to one or more functions, machine learning algorithms, or filtering algorithms (e.g., a Kalman filter, or the like). In some embodiments, a function, machine learning algorithm, or filtering algorithm may be configured to detect a trend in a measured battery parameter. In some embodiments, a function, machine learning algorithm, or filtering algorithm may be configured to generate a prediction of at least one of: degradation of properties or functions of the rechargeable battery, degradation of structural materials within the rechargeable battery, thickening or growth of an SEI layer of the rechargeable battery; a lithium inventory of the rechargeable battery, lithium plating associated with the rechargeable battery, swelling of the rechargeable battery, or an evolution of swelling or lithium plating associated with the rechargeable battery over time. Evolution of swelling or plating may be over a time period that exceeds at least about two weeks (e.g., two week, four weeks, eight weeks, etc.).

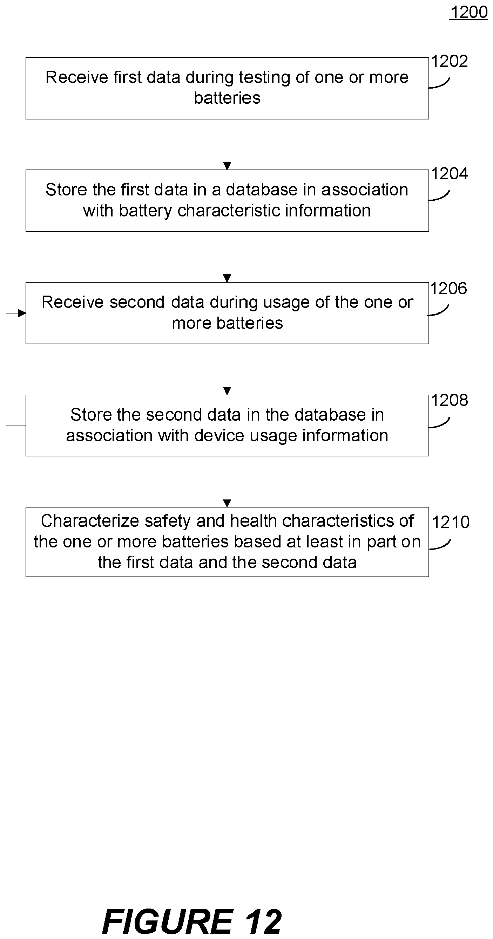

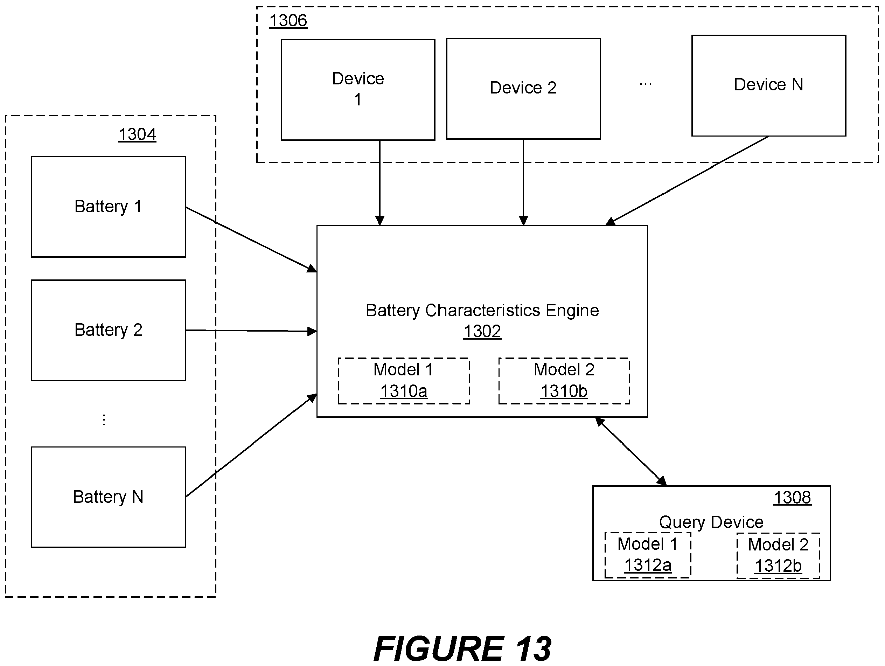

Note that in instances in which data is collected in order to predict future performance, the data may be collected during both charging and discharging of the battery. Data may be collected during a testing phase of a battery (e.g., in a test facility prior to usage of the battery), and/or during use of the battery (e.g., during charging and/or discharging when used to provide energy and power to a device). Data sets used to generate predicted future performance values may have millions, billions, trillions, etc. of data samples. As used herein, a "data sample" generally refers to a single measured or derived battery parameter associated with a battery element (e.g., a cell, pack, or module) obtained at a point in time. In some cases, a data set may be comprised of data samples associated with a common context, such as from a single battery pack, from batteries associated with a particular manufacturing batch, batteries manufactured by a particular vendor, batteries installed in a particular type of device (e.g., a particular mobile phone model, a particular vehicle model, etc.), batteries of a particular size or type, etc. For example, data may be collected from a battery on the order of every 0.1 seconds to 1 second, and the data may be stored locally on a computational device associated with a device being powered and/or transmitted to a remote server or cloud device. Moreover, a vehicle may have hundreds or thousands of battery cells, and data may be collected for each cell. For example, a car may have 300-3000 cells, a truck may have about 30,000 cells, and a train may have about 300,000 cells. More detailed techniques for collection and storage of battery data are shown in and described below in connection with Figures 12 and 13.

In some embodiments, based on the predicted future performance values of the battery, pack, or module, the techniques disclosed herein may perform an action. The action may include at least one of: identifying a future use pattern of the battery based on the predicted future performance values, presenting an alert indicating one or more predicted future performance values, identifying a future use pattern of a device to which the battery provides power and/or electrical energy, and/or identifying limits for present or future use (e.g., identifying a maximum usable SOC). For example, the future use pattern of the battery may include parameters to be used in future charging and/or discharging processes to be applied to the battery. As another example, a presented alert may indicate one or more predicted future performance values being below a predetermined threshold (e.g., a remaining useful life being below a predetermined threshold, an SOH, SOE, or SOP being below a predetermined threshold, etc.). In some embodiments, an alert may indicate the future time point for which the predicted future performance value is below a predetermined performance threshold. As yet another example, a future use pattern of a device may include modifications to operation of a vehicle based on the predicted future performance of the battery (e.g., that the vehicle is not to exceed traveling more than a predetermined number of miles, etc.), modification of a route the vehicle is to traverse, or the like. Note that the device may include a vehicle (e.g., a two-wheel vehicle, a four-wheel vehicle, a commercial delivery truck, a truck), a flight machine, an airplane, a stationary energy-storage system, a stationary or mobile charging station, or the like.

In some embodiments, modification of a use pattern of a battery or a device powered by the battery may be based on a comparison of a predicted future state of performance of the battery to a target performance value. For example, the modified use pattern of the battery or the device may be based on a difference between the predicted future state of performance and the target performance value. As described above, the modified use pattern may include a modified charging profile of the battery, a modified discharge profile of the battery, a modified use pattern of the device (e.g., a modified route a vehicle is to take, a modified upper speed limit a vehicle is permitted to travel at, etc.), or the like. In one example, the predicted future state of performance of the battery may be a predicted remaining useful life of the battery. Continuing with this example, the predicted remaining useful life may be compared to a target remaining useful life to determine a difference between the predicted remaining useful life (e.g., predicted based on current battery parameters, which may be measured or derived), and a target remaining useful life. Continuing further with this example, one or more modifications to the use pattern of the battery (e.g., charging or discharging profiles) and/or use pattern of the device powered by the battery may be determined based on the difference. In some embodiments, the modifications may be identified such that responsive to the use pattern being implemented, the future performance of the battery (e.g., the remaining useful life, or any other predicted future performance value(s)) move toward the target value. By way of example, in an instance in which the predicted remaining useful life is, e.g., two weeks, and the target remaining useful life is, e.g., eight weeks, implementation of the modifications to the use pattern of the battery and/or the device may cause the remaining useful life to increase from two weeks (e.g., to four weeks, six weeks, seven weeks, eight weeks, nine weeks, etc.). Note that although the example given above utilizes a predicted remaining useful life, in some embodiments, the predicted future performance value that is compared to a target performance value may be a predicted future SOP, SOE, SOH, remaining useful life, or any combination thereof. It should be understood that, in some embodiments, multiple predicted future performance values may each be compared to a target future performance value to determine one or more modifications to a use pattern of the battery and/or the device.

Note that, as described above, modification of a use pattern of a battery may include modifying a charging profile and/or modifying a discharge profile of the battery. Examples of charging process adaptations that may be implemented during charging of a battery include: modifying (e.g., reducing) a current and/or voltage (e.g., when a particular parameter value for SOC, time point, temperature, CPV, relaxation time, SOH, overpotential, estimated potential at one or more electrodes, etc. has been reached), ending charging prior to 100% SOC being reached (or prior to the equivalent maximum voltage being reached), modifying a duty cycle or frequency of charge pulses or packets, modifying a charging power (e.g., at a given SOC), reversing (e.g., occasionally reversing) a polarity at a given SOC or responsive to detecting a particular type of defect (e.g., lithium plating), modifying a charging rate, modifying a depth of charge, intermittent pausing of charging at a particular SOC, CPV, and/or temperature, or any combination thereof. Note that when charging is paused, the pause may be within a time range of anywhere from a few milliseconds to tens of seconds. The duration of the pause may be dependent on measured or derived battery parameters.

Examples of adaptations that may be implemented during discharge of a battery include: modifying a maximum discharge current magnitude (e.g., at a given SOC, temperature, or other parameter); modifying a discharge rate or its duration, limiting the depth of discharge (e.g., the difference between the minimum and maximum SOC or the minimum and maximum voltage); limiting a maximum power or energy output; limiting a maximum temperature rise; limiting a minimum terminal voltage or change in voltage for a cell, module or a pack, or any combination thereof. Further discussion of suitable adaptations is presented herein and in other patent applications in the context of "adaptive charging." See for example US Patent No. 11,397,215 and US Patent 11,397,216, which are incorporated herein by reference in their entireties.

It should be noted that, in some embodiments, adaptation of battery use pattern or device use pattern may be dynamic. For example, modifications to a battery use pattern or a device use pattern may be dependent on the device use case (e.g., whether a vehicle is being driven on a flat route or a hilly terrain, whether a vehicle is being driven on the freeway, traffic conditions, environmental conditions such as temperature, etc.) or battery use case. Moreover, adaptation of either battery use patterns or device use patterns may be selected to achieve a battery performance target, such as optimizing the capacity of a battery element or pack, optimizing voltage range, optimizing SOC, etc. Use patterns may be changed based on context such as device use case.

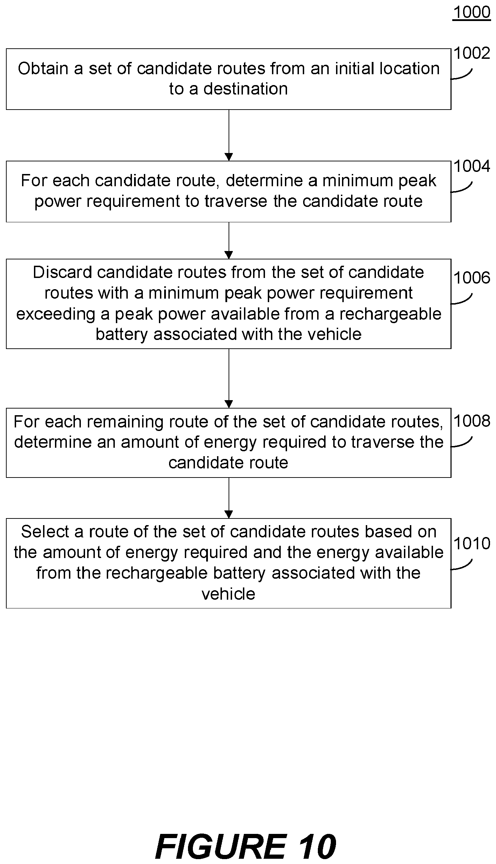

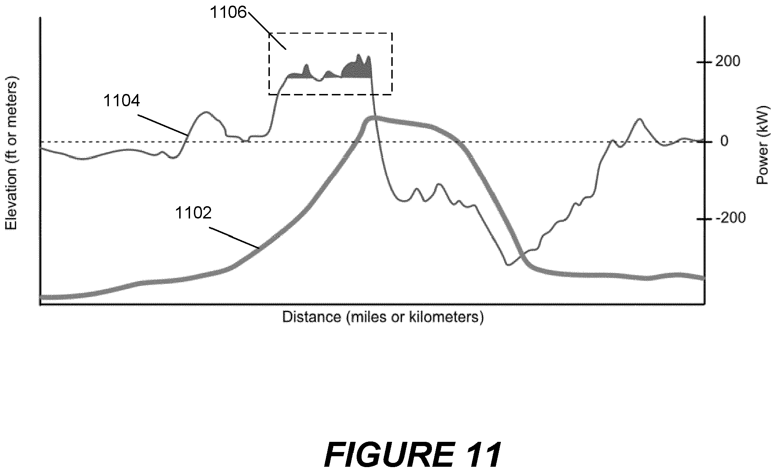

Additionally, it should be noted that in some cases, battery use pattern and/or device use pattern may be modified separately in conjunction so as to optimize battery safety and health. For example, in some cases, it may be determined that a device use pattern may be optimized (e.g., by selecting a particular type of route for a vehicle to traverse, as described below in connection with Figures 10 and 11), whereas in other cases, it may be determined that a battery use pattern may more effectively be optimized. In some cases, both a device use pattern and a battery use pattern may be modified concurrently. Each use pattern modification may be determined based on identifying and predicting battery degradation using one or more models, which may include a combination of machine learning models and physical models.

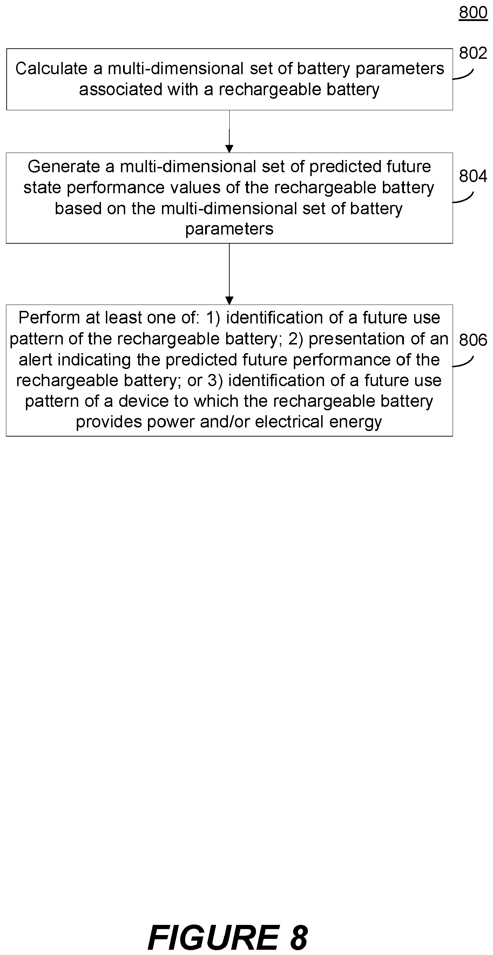

Figure 8 is a flowchart of an example process 800 for performing at least one action based on a predicted future state of performance value of a battery in accordance with some embodiments. Blocks of process 800 may be performed by monitoring and/or controlling circuitry associated with the battery. Note that one or more components of such as monitoring and/or controlling circuitry may be in proximity to the battery and/or may be remote from the battery (e.g., in the cloud). In some embodiments, blocks of process 800 may be performed in an order other than what is shown in Figure 8. In some embodiments, two or more blocks of process 800 may be performed substantially in parallel. In some embodiments, one or more blocks of process 800 may be omitted.

Process 800 can begin at 802 by calculating a multi-dimensional set of battery parameters associated with a rechargeable battery. It should be understood that a rechargeable battery as used herein may be a single cell battery, a battery pack, or a battery module. In instances in which the multi-dimensional set of battery parameters is associated with a pack or a module, there may be multiple sets of multi-dimensional set of battery parameters, each associated with a different battery cell or group of battery cells of the pack or module. As described above, the multi-dimensional set of battery parameters may include one or more measured parameters and/or one or more derived parameters (e.g., derived from one or more measured parameters). The derived parameters may be derived by applying a measured parameter to a function, machine learning algorithm, filtering algorithm, and/or a recursive estimation algorithm (e.g., a Kalman filter), as described above. The multi-dimensional set of battery parameters may include one or more of: an open circuit voltage of the rechargeable battery, a loaded circuit voltage of the rechargeable battery, a charge pulse voltage of the rechargeable battery, electrochemical impedance spectroscopy (EIS) information associated with the rechargeable battery, a capacity of the rechargeable battery, impedance information associated with the rechargeable battery, a current associated with the rechargeable battery, a temperature of the rechargeable battery, a state of charge (SOC) of the rechargeable battery, a state of safety of the rechargeable battery, a state of health (SOH) of the rechargeable battery, derivatives with respect to time of one or more measured battery parameters, or gradients with respect to a spatial region of one or more measured battery parameters. In some embodiments, the battery parameters may include predictions of degradation of properties or functions, degradation of structure materials, growth of an SEI layer, lithium inventory or prediction of lithium plating, swelling or a prediction of an evolution of swelling, or the like.

At 804, process 800 can generate a multi-dimensional set of predicted future state performance values of the rechargeable battery based on the multi-dimensional set of battery parameters. As described above, the multi-dimensional set of predicted future state performance values may include multiple time points in the future, e.g., six hours in the future, two weeks in the future, two months in the future, six months in the future, etc. In some instances, future time points may be represented as future charging cycles, e.g., after ten charging cycles, after fifty charging cycles, after two hundred charging cycles, etc. The multi-dimensional set of predicted future state performance values may be determined by applying any of the multi-dimensional set of battery parameters to one or more models (e.g., regression models, machine learning models, recursivee estimation algorithms, etc.) or functions. The predicted future state performance values may include predicted remaining useful life (RUL), SOP, SOE, SOH, predicted temperatures or temperature gradients, etc.

At 806, process 800 can perform at least one of: 1) identification of a future use pattern of the rechargeable battery; 2) presentation of an alert indicating the predicted future performance of the rechargeable battery; and/or 3) identification of a future use pattern of a device to which the rechargeable battery provides power and/or electrical energy. As described above, in some embodiments, identification of the future use pattern of the battery and/or the device may be determined based on a difference between one or more predicted future performance values (e.g., as indicated in the multi-dimensional set of predicted future state performance values) and a corresponding target performance value. Note that the difference may be at a specific future time point, e.g., a comparison between a predicted future performance value at six months in the future compared to a target value at six months in the future. Use patterns of the battery may include modifications to the charging profile and/or the discharge profile. Use patterns of the device, e.g., in an instance in which the device is a vehicle, may include a modification to a route the vehicle is to traverse, a maximum speed the vehicle is permitted to travel, or the like.

In some embodiments, one or more future performance metrics of a battery may be predicted based on a multi-dimensional set of battery parameters. The multi-dimensional set of battery parameters may include values of a set of battery parameters at different timepoints. As described above, in some instances, the one or more future performance metrics may be a multi-dimensional set of future performance metrics, e.g., a set of predicted performance values at different future time points. In some embodiments, the one or more future performance metrics may include estimates of one or more of SOP, SOE, state of capacity, SOH, RUL,cell temperature, battery/pack temperature gradients, or any combination thereof at one or more future times.

In some embodiments, the one or more future performance metrics may be predicted with a relatively high level of accuracy (e.g., relative to conventional techniques) due at least in part to a relatively high sampling frequency of battery measurements utilized to determine the multi-dimensional set of battery parameters. For example, the values of the battery parameters may correspond to timepoints having a sampling frequency of greater than about 10 Hz, greater than about 50 Hz, greater than about 100 Hz, greater than about 200 Hz, greater than about 250 Hz, or the like. By sampling measured battery parameters and/or determining derived battery parameters at a relatively high frequency (e.g., at least multiple times per second, or even hundreds of times per second), trends in battery parameters may be determined with high accuracy, which may in turn lead to more accurate predictions of future battery performance. Note that predicted values of future battery performance may be determined for future time points that are greater than about 1 month in the future (e.g., 1 month in the future, 2 months in the future, 6 months in the future, etc.) or at future times greater than about 200 charging cycles (e.g., after 200 charging cycles, after 500 charging cycles, or the like).

It should be noted that once an alert or action has been taken, subsequent actions may be automatically initiated based on the initial alert or action. For example, in an instance in which process 800 causes an alert to be presented, e.g., on a dashboard of a vehicle, subsequent actions may include causing performance of a series of diagnostic tests (e.g., at a dealership, test facility, etc.). The subsequent series of diagnostic tests may be tests that are selected based on the multi-dimensional set of predicted future state performance values. For example, values of a particular feature being outside of predetermined threshold range may cause corresponding diagnostic tests to be performed to identify a likely cause or location of an identified failure.

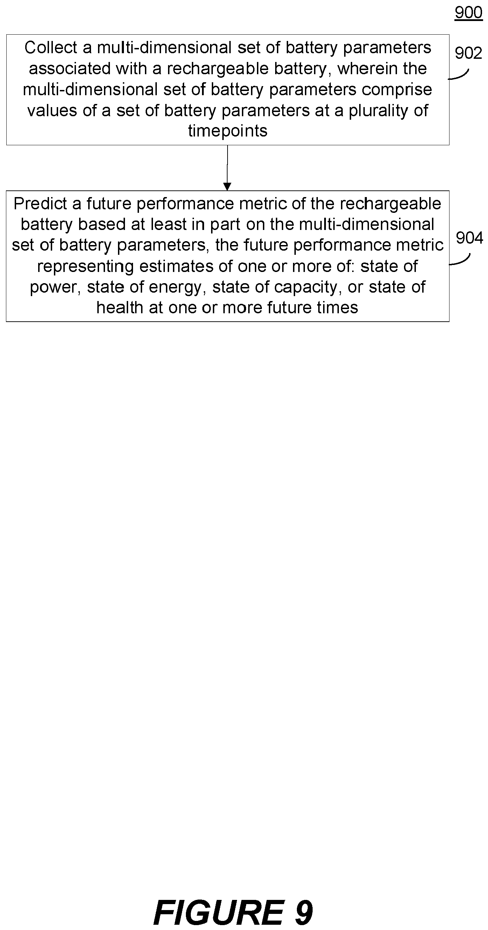

Figure 9 is a flowchart of an example process 900 for determining one or more predicted future performance metrics of a rechargeable battery in accordance with some embodiments. Blocks of process 900 may be performed by monitoring and/or controlling circuitry associated with the battery. Note that one or more components of such monitoring and/or controlling circuitry may be in proximity to the battery or may be remote from the battery (e.g., in the cloud). In some embodiments, blocks of process 900 may be performed in an order other than what is shown in Figure 9. In some embodiments, two or more blocks of process 900 may be performed substantially in parallel. In some embodiments, one or more blocks of process 900 may be omitted.

Process 900 can begin at 902 by collecting a multi-dimensional set of battery parameters associated with a rechargeable battery, where the multi-dimensional set of battery parameters comprise values of a set of battery parameters at a plurality of timepoints. It should be understood that a rechargeable battery as used herein may be a single cell battery, a battery pack, or a battery module. In instances in which the multi-dimensional set of battery parameters is associated with a pack or a module, there may be multiple sets of multi-dimensional set of battery parameters, each associated with a different battery cell or group of battery cells of the pack or module. As described above, the multi-dimensional set of battery parameters may include one or more measured parameters and/or one or more derived parameters (e.g., derived from one or more measured parameters). The derived parameters may be derived by applying a measured parameter to a function, machine learning algorithm, recursive estimation algorithms, and/or filtering algorithm, as described above. The multi-dimensional set of battery parameters may include one or more of: an open circuit voltage of the rechargeable battery, a loaded circuit voltage of the rechargeable battery, a charge pulse voltage of the rechargeable battery, an overpotential, an internal estimate of electrode potentials, electrochemical impedance spectroscopy (EIS) information associated with the rechargeable battery, a capacity of the rechargeable battery, impedance information associated with the rechargeable battery, a current associated with the rechargeable battery, a temperature of the rechargeable battery, a state of charge (SOC) of the rechargeable battery, a state of safety of the rechargeable battery, a state of health (SOH) of the rechargeable battery, derivatives with respect to time of one or more measured battery parameters, or gradients with respect to a spatial region of one or more measured battery parameters. In some embodiments, the battery parameters may include predictions of degradation of properties or functions, degradation of structure materials, growth of an SEI layer, lithium inventory or prediction of lithium plating, swelling or a prediction of an evolution of swelling, or the like.

Note that the plurality of timepoints at which the battery parameter values correspond may have a sampling frequency of greater than about 10 Hz, greater than about 50 Hz, greater than about 100 Hz, greater than about 200 Hz, greater than about 250 Hz, or the like. Each dimension of the set of multi-dimensional battery parameters may correspond to a different timepoint of the plurality of timepoints.

At 904, process 900 can predict a future performance metric of the rechargeable battery based at least in part on the multi-dimensional set of battery parameters. The future performance metric may represent estimates of one or more of a state of power (SOP), state of energy (SOE), state of capacity, and/or state of health (SOH). The future performance metrics may be predicted for one or more future time points. The one or more future time points may be greater than about 1 month in the future, greater than about 2 months in the future, greater than about 6 months in the future, greater than about 200 charging cycles in the future, greater than about 500 charging cycles in the future, or the like. The one or more future performance metrics may be determined by applying the multi-dimensional set of battery parameters to one or more models (e.g., a regression model, a trained machine learning model, etc.) or a function.

In some embodiments, predicted future battery performance of a battery (which may be a battery pack or module) may be determined and utilized to make one or more decisions related to a vehicle powered by the battery. For example, in some embodiments, an optimal route may be selected from a set of candidate routes based on the predicted future battery performance. As a more particular example, a candidate route may be selected as one with power and/or energy requirements required to traverse the route that meet available power and/or energy constraints of a battery to be used to power the vehicle. In one example, a predicted SOP and/or SOE associated with a battery may be compared to power requirements and/or energy requirements associated with a given route to determine an ability of a vehicle powered by the battery to traverse the given route. By way of example, in some embodiments, a set of candidate routes may be obtained that traverse from an initial location to a destination location. For each candidate route, a minimum peak power requirement may be determined. The minimum peak power requirements may be compared with predicted battery performance metrics to discard one or more of the candidate routes. For example, in some embodiments, candidate routes with a minimum peak power requirement that exceed a peak power available from the battery may be discarded. Note that a peak power requirement associated with a given route may be determined based on a terrain of the route, e.g., based on a maximum grade of a portion of the route or the like. Continuing with this example, in some embodiments, after discarding candidate routes with peak power requirements that may not be met by the battery, an amount of energy required to traverse each candidate route may be determined. Based on the energy requirements, a route of the candidate routes may be selected based on the energy available from the battery configured to power the vehicle. Note that the energy available may include energy that may be available during the journey due to regenerative braking. For example, in some embodiments, a route associated with the minimum energy requirement may be selected. As another example, in some embodiments, a route associated with an energy requirement that may be satisfied by the battery and that is associated with the least amount of traffic may be selected. In some embodiments, a route of the candidate routes may be selected based on energy considerations in combination with any other combination of factors, such as traffic, types of waypoints along the route (e.g., rest stops, etc.), remaining useful life of the battery, or the like. It should be understood that selection of routes and/or predictions of battery performance may be determined at future time points, e.g., at greater than about 20 charging cycles, greater than about 100 charging cycles, greater than about 200 charging cycles, etc.

In some embodiments, determining characteristics associated with a candidate route, such as minimum peak power requirements, may be determined based on conducting a simulation of the candidate route. In some implementations, a simulation of a given route may consider a terrain of the route, traffic (or expected traffic, e.g., based on time of day and/or time of week) along the route, speed limits along the route, a gross vehicle weight of a vehicle to traverse the route, weather conditions (or expected weather conditions, e.g., based on a forecasted weather prediction, time of year, or the like) along the route, and/or drive-train characteristics of the vehicle.

It should be understood that, as used herein, a vehicle may be a two-wheeled vehicle, a four-wheeled vehicle (e.g., a car, a truck, a commercial delivery truck, or the like), an airplane, an unmanned aerial vehicle, a maritime vessel, or the like. A vehicle may be autonomous, semi-autonomous, or not autonomous.

Figure 10 is a flowchart of an example process 1000 for selecting a route from a set of candidate routes based on battery performance metrics in accordance with some embodiments. In some embodiments, blocks of process 1000 may be performed by a computing device, which may be local to or remote from a battery to power a vehicle that is to traverse one of the candidate routes. For example, in some embodiments, one or more blocks of process 1000 may be performed in the cloud. In some embodiments, blocks of process 1000 may be performed in an order other than what is shown in Figure 10. In some implementations, two or more blocks of process 1000 may be performed substantially in parallel. In some implementations, one or more blocks of process 1000 may be omitted.

Process 1000 can begin at 10020 by obtaining a set of candidate routes from an initial location to a destination. The set of candidate routes may be identified based on a map of a region that includes the initial location and the destination such that each candidate route begins at the initial location and ends at the destination. Each route may be a combination of freeways and surface streets or the like.

At 1004, for each candidate route, process 1000 can determine a minimum peak power requirement to traverse the candidate route. In some cases, the minimum peak power requirement may primarily be dependent on the terrain of the candidate route, e.g., a maximum grade to be traversed over the candidate route. In some implementations, the minimum peak power requirement may additionally or alternatively be dependent on speed limits along the route, weather conditions (or predicted weather conditions) along the route, traffic conditions (or predicted traffic conditions) along the route, characteristics of the vehicle to traverse the route (e.g., drive-train characteristics, gross vehicle weight, or the like).

At 1006, process 1000 can discard candidate routes from the set of candidate routes having a minimum peak power requirement that exceeds a peak power available from a rechargeable battery (which may be a battery pack or module) of the vehicle. Note that, in some embodiments, no candidate routes may be discarded, e.g., in instances in which the minimum peak power requirement for each candidate route is less than a peak power available from the rechargeable battery.

By way of example, turning to Figure 11, a graph is depicted which illustrates elevation curve 1102 and power requirements curve 1104 for a given candidate route as a function of distance along the route. Note that, in general, power requirements increase in conjunction with increases in elevation, e.g., more power is required to climb hills. Power requirements curve 1104 includes a portion 1106 in which the peak power requirements for that portion of the route exceed the peak power available from a battery associated with a vehicle to traverse the route. Accordingly, based on the existence of portion 1106 in which the peak power requirements of the candidate route exceed the peak power available from the battery, the candidate route depicted in Figure 11 may be discarded from the set of candidate routes.

Referring to Figure 10, at 1008, for each of the remaining routes of the set of candidate routes, process 1000 can determine an amount of energy required to traverse the candidate route. The amount of energy required may be based on the distance of the route, an estimated time required to traverse the route (which may in turn be dependent on traffic conditions and/or predicted traffic conditions), or the like.

At 1010, process 1000 can select a route of the set of candidate routes based on the amount of energy required and the energy available from the rechargeable battery of the vehicle. For example, in some embodiments, process 1000 can select the candidate route with the lowest energy required. As another example, in some embodiments, process 1000 can select the route based on any combination of energy requirements and other factors, such as expected traffic, way points along the route, safety risks associated with the route, or the like. In some embodiments, process 1000 may select a route in which the energy available from the battery exceeds the energy required to traverse the route by at least a predetermined headroom amount, e.g., with at least a 10% energy headroom, at least a 20% energy headroom, or the like. In some embodiments, the predetermined headroom amount may be dependent on the type of route to be traversed, e.g., whether the route is primarily through a mountainous or flat terrain, the expected amount of energy from regenerative braking, or the like.

Note that, in some embodiments, process 1000 may be executed to select a route to be traversed by a vehicle using a given battery at a future time. The future time may be, e.g., one month in the future, two months in the future, etc., or 10 charging cycles in the future, 50 charging cycles in the future, 100 charging cycles in the future, 200 charging cycles in the future, etc.

Additionally, it should be noted that although the techniques described herein generally describe selecting a route for a given vehicle, in some implementations, a vehicle may be selected from a set of available vehicles to traverse a given route. In such implementations, characteristics associated with the route to be traversed, such as minimum peak power requirements, total energy required, or the like may be determined. These characteristics may be determined based on a simulation of the route, which may consider train, traffic conditions, weather conditions, braking (regenerative and non-regenerative) conditions, etc. Based on the power and energy characteristics of the route, a vehicle from a set of vehicles may be selected, where the selected vehicle may be powered by a battery (which may be a battery pack or a battery module) that meets the power and energy requirements to traverse the route.

As described above in connection, in some embodiments, a large dataset of battery data may be used to make predictions regarding battery health and safety characteristics, determine optimizations to be performed to maximize battery and health and safety (e.g., where the optimization may include any combination of modification of battery use patterns such as charging and discharging characteristics and/or modification of device use patterns), etc. The dataset used to make predictions and identify optimizations may comprise data collected from hundreds, thousands, millions, billions, etc. of batteries on a cell level, pack level, and/or module level, and from hundreds, thousands, millions, billions, etc., devices. The data may be collected on a sub-second time frame. Accordingly, the dataset may be vast in size. Such a dataset may be stored in one or more databases, servers, and/or cloud devices. The data may correspond to batteries of different models or types, used to power different types of devices (e.g., vehicles, mobile phones, computers of difference sizes/types, appliances, vessels, etc.), and/or used in different scenarios (e.g., vehicles traversing different terrain, vehicles traveling under different environmental conditions, devices or appliances operating at different temperatures, etc.). The data may be collected at different stages of a battery lifecycle, e.g., during a testing phase prior to deployment in the field, during regular usage, during charging conditions, during discharging conditions, before or after identification of a battery health or safety issue, before or after one or more modifications to a battery use pattern and/or device use pattern have been implemented, etc.

In some embodiments, the collected data may be structured, and such structure may be utilized to form or determine one or more predictions. For example, the data may be structured based on battery type/model/manufacturer, type of device powered (e.g., type of vehicle, type of appliance, type of user device, etc.), conditions the powered device is used (e.g., a type of terrain traversed by a vehicle, a type of environmental condition the device is operated at, etc.), or the like. For example, collected data may include one or more measured or derived battery parameters, and the data may be stored in association with indications of the context in which the data was collected. The context may include, as described above, battery type, device type, device operation conditions, time of day, temperature, etc. The context may additionally or alternatively include battery characteristics, such as a current SOP, SOE, SOC, etc. associated with the battery. Note that, in some cases, the battery characteristics may include identifications of particular defects that have been identified as having occurred or likely to occur. Such identifications may be used to generate predictions of conditions under which these defects are likely to occur in order to mitigate the defects. The structured battery data may be used to, e.g., query a database to identify data associated with a particular context or combination of contexts. For example, data associated with batteries made by a particular manufacturer may be identified. As another example, data associated with batteries used by a vehicle of a particular type (e.g., a four-wheeled car, a bus, a train, a motorcycle, etc.) traversing a type of terrain (e.g., hilly, flat, etc.) may be identified. In some embodiments, the database may be queried by one or more user devices, such as a laptop computer, a desktop computer, etc., that requests data matching particular search criteria.

In some embodiments, the collected data may be analyzed to identify patterns. Such patterns may include that a particular defect occurs with a particular type of battery, that a particular defect occurs under particular use conditions, that a particular battery use pattern and/or device use pattern modification delays or stops onset of a particular defect, or the like. As one example, an identified pattern may be that a particular defect occurs with a particular type of battery used to power a vehicle that traverses terrain exceeding a particular grade. As another example, an identified pattern may be that a particular defect occurs when a battery is used at a SOP, SOE, or SOC outside of a predetermined range. As yet another example, an identified pattern may be that a particular defect may be delayed or prevented when a battery use pattern (e.g., a charging characteristic and/or a discharging characteristic) is changed from a first pattern to a second pattern. Note that an identified pattern may comprise any combination of type of defect, time to defect, type of battery, type of user device, and/or battery usage context.

In some embodiments, an identified pattern may be used to automatically (e.g., without user input) make decisions. For example, a decision may include a type of battery to be used for a particular type of device and/or a particular use case. As a more particular example, identified patterns may be used to select a particular battery for a four-wheeled vehicle, such as a taxi, that will primarily be driving multiple hours per day within a city. Continuing with this example, a different battery may be identified for the same type of four-wheeled vehicle that will be operated in a different context, such as primarily for morning and evening commuting on freeways.

A pattern may be identified using a model. The model may be a statistical model and/or a trained machine learning model. A trained machine learning model may have any suitable architecture, such as a deep neural network, a classifier, a regression model, etc. In one example, a trained machine learning model may be a deep neural network having multiple (e.g., five, ten, twenty, etc.) layers. In another example, a trained machine learning model may be a large language model. In some embodiments, a machine learning model may be trained on data stored in the database described above. In some cases, identified defects may serve as ground truth training labels the machine learning model is trained to identify. Such a model may then be used to predict defects using test battery data (e.g., during an inference stage). Note that models may be trained on gigabytes, terabytes, etc. of data which may allow predictions to be made with granularity, e.g., to identify differences between different types of batteries, different device types, different operating conditions, etc. Note that, in some embodiments, a model may be trained on data from batteries, where the data corresponds to batteries that include a particular type of defect or anomaly. Such data may be obtained from physical systems or from simulations (e.g., from simulations of particular types of battery defects or anomalies).

In some embodiments, a dataset or data stored in a database as described above may be analyzed to generate new optimizations. For example, new optimizations may include a new route for a vehicle that is predicated on battery data. As a more particular example, responsive to identifying a pattern that a vehicle utilizing a particular type of battery that traverses a route having a grade exceeding a particular threshold is more likely to experience a battery defect, a new route may be identified that traverses the same starting point and ending point but that only includes terrain below the grade threshold. As another example, a new optimization may include a particular charging profile and/or discharging profile for batteries of a particular type and/or batteries used in particular contexts. In some embodiments, the dataset or the data stored in the database may be used to generate new battery designs. For example, in some embodiments, the data may be used to design a battery subject to various constraints (e.g., will charge in a duration of time below a predetermined charging threshold, utilizes particular materials, having a particular capacity, etc.), where the constraints may be used to specify minimum performance specifications and design considerations that will cause the battery to be manufactured in less than a predetermined cost.

Figure 12 is a flowchart of an example process 1200 for characterizing safety and health characteristics of batteries based on collected and stored data in accordance with some embodiments. Blocks of process 1200 may be performed by one or more processors and/or controllers of a remote computing device (e.g., a server, a cloud device, etc.), and/or one or more processors and/or controllers of a local device (e.g., a laptop computer, a desktop computer, a GPU, a server, etc.). In some embodiments, blocks of process 1200 may be executed in an order other than what is shown in Figure 12. In some embodiments, two or more blocks of process 1200 may be executed substantially in parallel. In some embodiments, one or more blocks of process 1200 may be omitted.

Process 1200 may begin at 1202 by receiving first data during testing of one or more batteries. For example, the first data may be obtained during a testing stage, e.g., in a manufacturing facility. The first data may include one or more measured and/or derived battery parameters, which may include voltage data, current data, temperature data, EIS data, SOC, SOP, SOE, capacity information, etc. The one or more batteries may be subjected to one or more tests to obtain the first data. The first data may be received at a remote device, such as a server or a cloud device. The data may be transmitted via the Internet, or any other suitable communication channel.

At 1204, process 1200 can store the first data in a database in association with battery characteristic information. The database may be stored in memory of a server device, a cloud device, etc. The battery characteristic information may include battery type information (e.g., materials of the battery, a make or model, a name of a manufacturer, a data of manufacturer, etc.), timing information indicating times the first data were collected, tests the battery was subj ected to, etc.

At 1206, process 1200 can receive second data during usage of the one or more batteries. Note that usage of the one or more batteries may comprise use of the one or more batteries to power a device, such as a computing device, an appliance, a vehicle, an energy storage device, etc. The second data may include data collected during charging of the battery and/or discharging of the battery. The second data may include one or more measured and/or derived battery parameters, as described above. The second data may additionally include data associated with the device, such as the type of device, conditions under which the battery was used (e.g., environmental conditions, terrain conditions of a vehicle powered by the battery, etc.).

At 1208, process 1200 can store the second data in the database in association with the device usage information.

Process 1200 can loop through blocks 1206 and 1208 hundreds, thousands, millions, billions, etc. of times. Accordingly, the database may store battery parameters during usage of the battery over many stages of the battery lifecycle from before deployment (e.g., as described above at blocks 1202 and 1204), through usage of the battery to power one or more devices over multiple charge-discharge cycles. Note that, in some embodiments, a given battery may power a first device during a first set of loops through blocks 1206 and 1208, and may power a second device during a second set of loops through blocks 1206 and 1208, e.g., in an instance in which a battery is moved from the first device to the second device. The change in devices may be reflected in the device usage information stored in association with the second data.

At 1210, process 1200 can characterize safety and health characteristics of the one or more batteries based at least in part on the first data and the second data. For example, as described above, process 1200 can apply one or more models to the first data and the second data to identify patterns associated with a particular battery type, a particular usage context, etc.

It should be noted that blocks of process 1200 may execute asynchronously. For example, in some embodiments, testing data (described as "first data" in connection with process 1200) may be obtained with a group of batteries undergoing pre-deployment testing. At the same time (e.g., simultaneously, or near simultaneously), field usage data (described as "second data" in connection with process 1200) may be obtained with a second group of batteries that have already been tested and deployed. This may be repeated for multiple (e.g., hundreds, thousands, millions, etc.) groups of batteries concurrently such that the database stores data associated with many different batteries which may be at different stage of their lifecycle.

Figure 13 illustrates an example system for storing data in a database and generating predictions and optimizations using the collected and stored data in accordance with some embodiments. It should be noted that the system illustrated in Figure 13 may be used for identifying battery or device use pattern modifications as described above in connection with Figure 8, predicting future battery performance metrics as described above in connection with Figure 9, optimizing vehicle routes as described above in connection with Figure 10, and/or storing battery data and utilizing the battery data for optimizing battery usage and/or device usage and/or developing new battery optimizations and designs, as described above in connection with Figure 12.

As illustrated, the system may include a battery characteristics engine 1302. Battery characteristics engine 1302 may be implemented as one or more server devices, cloud computing devices, etc. In some embodiments, battery characteristics engine 1302 may store (e.g., in memory) a database that stores and/or organizes battery data collected from multiple batteries. For example, as shown in Figure 13, set of batteries 1304 (which includes A batteries) may be tested to obtain testing stage battery data, which may be transmitted to battery characteristics engine 1302. As described above in connection with Figure 12, the battery data may be collected as part of a testing process, e.g., at a manufacturing facility. As another example, as shown in Figure 13, set of devices 1306 may transmit battery data associated with batteries in use to battery characteristics engine 1302. Note that the devices represented in set of devices 1306 may be different types of devices, e.g., vehicles, computing devices, personal devices, appliances, etc. The battery data may be transmitted from multiple batteries at a sub-second time scale and stored in memory of battery characteristics engine 1302.

In some embodiments, a query device 1308, which may be a laptop device, a desktop computer, a tablet computer, etc. may be used to query a database stored by battery characteristics engine 1302. For example, query device 1308 may query the database to retrieve data pertaining to particular types of batteries, batteries used by particular types of devices, batteries used under particular types of conditions (e.g., by vehicles traversing particular types of routes, by devices operated under particular environmental conditions, etc.), or the like. The retrieved data may then be transmitted back to query device 1308. Note that although only one query device is illustrated in Figure 13, in some embodiments, multiple (e.g., two, ten, one hundred, one thousand, etc.) query devices may make queries.

As described above, in some embodiments, battery patterns (e.g., predicted occurrence of defects, predicted safety and health characteristics, predicted future performance metrics, etc.) may be identified using one or more models which may be applied to the data or a subset of the data stored in the database. These models may be executed by battery characteristics engine 1302 (e.g., by one or more processors of a server or cloud computing device) and/or by a user device such as query device 1308. For example, a server device may execute models 1310a and/or 1310b, and query device 1308 may execute models 1312a and/or 1312b.

Note that models 1310a, 1310b, 1312a, and 1312b may each by any type of model. Types of models that may be used include statistical models, physical models that model known physical phenomena (e.g., circuit models, numeric simulations of physical phenomena, etc.), and/or machine learning models (e.g., neural networks, regression models, decision trees, clustering algorithms, etc.). In some embodiments, multiple types of models may be used and results of the multiple types of models combined to generate a single type of prediction. In one example, a physical model may be used to model some aspects of lithium plating. For example, a physical model may be used to characterize or estimated anode voltage, where plating is likely to occur when the anode threshold drops below a threshold voltage. Models may be three-dimensional, or may be reduced models to one or two dimensions. In some embodiments, a model may be parameterized. The physical model may model changes in the anode voltage, e.g., as a function of battery terminal voltage, time, or the like. Continuing with this example, a machine learning type model may be used to model phenomena that cause lithium plating which may not be easily modeled with a physical model. Such phenomena may include the reabsorption of lithium back into the electrolyte. The physical model (representing changes in the anode voltage) may be combined with the machine learning or statistical model which may characterize onset of plating with respect to lithium reabsorption to generate more accurate predictions of lithium plating onset. Note that a statistical model or machine learning model may inherently model multiple types of batteries to arrive at a more accurate statistical prediction.

In some embodiments, outputs of two different types of models (e.g., a physical model and a machine learning model) may be combined by generating predictions (e.g., of future battery performance metrics) using each model. Note that, in some embodiments, different numbers of predictions may be generated with each, and each type of prediction may be different. For example, a physical model may be used to generate a prediction regarding anode voltage changes, whereas a machine learning model may be used to generate one or more statistical predictions. In some embodiments, a physical model may include one or more models of the physical and/or chemical properties internal to a battery. Examples of such models are described in United States Patent No. 11,397,215, which is hereby incorporated by reference in its entirety and for all purposes. In other words, a first model may be used to generate one or more predictions, and a second model may be used to generate one or more predictions, and the number of predictions generated using the first model and the second model may be different, and the types of predictions may be different. The predictions may then be aggregated to generate an aggregate prediction for a battery cell, pack, or module. For example, predicted performance metrics may be averaged (e.g., by finding a mean, median, etc.). As another example, for a battery pack or module, individual cells or packs may be ranked based on predicted future metrics, and an aggregate score may be assigned based on the ranking.

It should be noted that the techniques described herein generally relate to closed-loop optimization of batteries. As used herein, "closed-loop" control or optimization generally describes monitoring battery characteristics, and instigating one or more actions to optimize performance of the battery (e.g., to delay a battery defect, to mitigate a battery defect, and/or to prevent a battery defect). Closed-loop control or optimization may include short-tern optimization, and/or long-term optimization. In general, short-term closed-loop control may include changes to battery use patterns, such as changing to charging and/or discharging characteristics (e.g., changing a charging voltage or current, changing a depth of discharge, etc.) in order to prolong battery life, delay or prevent a battery defect, etc. Long-term closed-loop control may include steps to mitigate battery aging over, e.g., hundreds or thousands of battery charge/discharge cycles. Long-term closed-loop control may include vehicle route plan changes (e.g., to change a traversed terrain), constraining use of a device to particular environments or operating under particular environmental conditions, etc. In some embodiments, long-term closed-loop control may additionally or alternatively include periodic updates to a vehicle or to system software. For example, updates may be delivered as over the air (OTA) updates to battery control logic.

### Apparatus

The battery charging system may have many configurations. In some cases, all or most of the measured battery parameter values (e.g., current, voltage, and temperature) are collected by a single module or circuit, while in other cases, the parameter values are collected by multiple modules and/or circuits. Battery monitoring circuits and/or charging circuits may be used for this purpose. In some cases, the battery control logic, whether operating alone or in conjunction with battery monitoring and/or charging circuitry, may be used to collect the parameter values. In certain embodiments, the parameter values are collected by a module, circuit, or logic that is directly connected to a battery such as a circuit or a module that is physically attached to, mounted on, or encased in an electronic device housing the battery. In other embodiments, the parameter values are collected by a module, circuit, or logic that is distant from the battery and/or the electronic device powered by the battery. For example, the module, circuit, or logic may be coupled to the battery and/or device by a wired or wireless link.

The apparatus that operates the battery control logic may be the same apparatus used to collect the battery parameter values or may be a distinct apparatus such as a mobile device, a server, or a distributed collection of remote processing devices. In some implementations, a cloud-based application is used to store and operate the battery control logic. In certain embodiments, the apparatus used to collect battery use parameters is also used to adaptively charge a battery.

**Figure 1** depicts in block form a battery monitoring/charging system that may be configured to prevent or reduce defects by adaptively charging a battery. The apparatus includes charging circuitry **112** that responds to control signals to generate a charge signal that is applied to the terminals of the battery. The apparatus also includes measurement circuitry **114** coupled to the battery, to measure voltage, current, and/or other battery parameter values that may be used for adaptive charging. Control circuitry **116** is coupled to the charging circuitry and the measuring circuitry. Using data received by the monitoring circuitry the control circuitry is configured to generate one or more control signals to adapt one or more characteristics of a charging signal and/or discharging signal in the context of adaptive charging. In some cases, the control circuitry may also play roles in monitoring battery performance and collecting battery parameter values.

### Charge Circuitry

In one embodiment, charging circuitry **112** applies one or more charge signals to the battery in response to control circuitry. The charge signals applied by the charging circuitry may include one or more charging signals which provide a net input of charge or current into the battery (see, for example, **Figures 3a** and **3b**) and one or more discharging signals which provide a net removal of charge or current from the battery (see, for example, **Figures 3c** and **3d**).

The adaptive charging circuitry and techniques may employ any charging circuitry, whether described herein, now known or later developed, to charge the battery; all such charging circuitry are intended to fall within the scope of this disclosure. For example, charging circuitry may generate charge and discharge signals, packets, and pulses (as described herein). Notably, charging circuitry is generally responsive to control signals from the control circuitry.

Discharge signals remove charge from the battery and may be employed to reduce the time period for the battery terminal voltage to return to equilibrium. In this regard, the discharge period may remove excess charge that might otherwise contribute to degradation mechanisms such as the growth of the solid-electrolyte interface (SEI) layer or metallic plating of lithium. Clearly, the difference between the electrical charge added to the cell during a charging period and the electrical charge removed from the cell during a discharge period determines a net total electrical charge added to the cell in one period. This net total electrical charge divided by the period may determine a net effective charging current. All combination or permutations of charge signals are provided by the charge circuitry and are intended to fall within the scope of the present disclosure.

### Monitoring Circuitry

Monitoring circuitry **114** measures, monitors, senses, detects and/or samples, on a continuous or periodic basis (e.g., at predetermined states of charged) one or more conditions or characteristics of the battery. For example, the monitoring circuitry may measure the terminal voltage (an open circuit voltage (OCV) or a closed circuit voltage (CCV)), overpotential, relaxation time, the voltage response of the battery to one or more charge pulses, and/or temperature of the battery. In one embodiment, the monitoring circuitry includes a sensor to determine a voltage (for example, a voltmeter) and/or a sensor to determine a current (for example, a current meter). The monitoring circuitry provides data which is representative of the condition or characteristics of the battery to the control circuitry. Moreover, the monitoring circuitry may include one or more temperature sensors which are thermally coupled to the battery to generate, measure, and/or provide data which is representative of the temperature of the battery. The monitoring circuitry and techniques may be those described herein, now known or later developed, to acquire data employed by the control circuitry to adapt the charging profile of the battery; all such monitoring circuitry and techniques are intended to fall within the scope of this disclosure.

### Control Circuitry

In certain embodiments, the control circuitry **116,** using data from monitoring circuitry, calculates, determines and/or assesses the state or condition of the battery in connection with the charging or recharging process. For example, control circuitry may calculate, determine and/or estimate a change in terminal voltage of the battery in response to charge or current applied to or injected into the battery. The control circuitry may also calculate, determine and/or estimate one, some, or all of the SOC of the battery, SOH of the battery, partial relaxation time of the battery and/or overpotential or full relaxation time of the battery.

The control circuitry may also calculate, determine, and/or implement a charging sequence or charging profile based on or using one or more of the adaptive charging techniques and algorithms. For example, the control circuitry may be configured to implement any of the charge or discharge adjustments described herein to address defects or potential defects. In this regard, control circuitry adapts, adjusts and/or controls one or more characteristics of the charge or current applied to or injected into the battery (via controlling the operation of charging circuitry) so that the terminal voltage, the change in terminal voltage, or another battery parameter (in response to charge or current applied to or injected into the battery during a charging or recharging sequence/operation) is within a predetermined range and/or below a predetermined value. In this regard, one or more characteristics of the charge signal may be adapted to control and/or manage battery parameters such as the terminal voltage, or a relaxation time. In addition to adapting the sequence of charge signals, discharge signals and rest periods - in relation to each other - the control circuitry may vary, adjust and/or control one or more of the variable characteristics of a charge signal. In some cases, the control circuitry may be configured to obtain or provide a desired or predetermined relaxation time or period (for example, a relaxation time that is within prescribed range), by adjusting and/or controlling the amount of electrical charge removed during a discharge period, the amount of electrical charge added during a charge period, and/or the characteristics of a rest period. In one embodiment, the adaptive charging technique or algorithm employs a sequence of discharge signals where the relaxation time is calculated, determined and/or measured after each of the discharge signals. In this way, the control circuitry may adaptively determine the total amount of electrical charge that should be removed (and, in response thereto, control the charging circuitry accordingly).

There are numerous permutations involving the amount of electrical charge added to the battery during the charge signal and the amount of charge removed during the discharge signal. All permutations are intended to fall within the scope of the present disclosure. Notably, each permutation may result in a different relaxation period. Moreover, within each permutation, there exists a large number of sub-permutations that i) combine the characteristics of a charge signals (for example, the duration, shape and/or amplitude of the charge signal), the product of which determines the amount of electrical charge added to the cell; and ii) combine the characteristics of a discharge signal (for example, the duration, shape and/or amplitude of a discharge signal), the product of which determines the amount of electrical charge removed from the cell; and iii) the length of time of the rest period. The characteristics of a charge signals may differ from the characteristics of a discharge signals. That is, one or more of the duration, shape and/or amplitude of the charge signal may differ from one or more of the duration, shape and/or amplitude of the discharge signal.

Notably, control circuitry may include one or more processors, one or more state machines, one or more gate arrays, programmable gate arrays and/or field programmable gate arrays, and/or a combination thereof. Indeed, control circuitry and monitoring circuitry may share circuitry with each other as well as with other elements; such circuitry may be distributed among a plurality of integrated circuits which may also perform one or more other operations, which may be separate and distinct from that described herein. In some embodiments, control circuitry may be housed within a device containing the battery. Alternatively, a battery may be housed in an electronic device, while control circuitry may be housed elsewhere. For example, control circuitry may operate on a remote server or a cloud-based application. In some cases, control circuitry may be coupled to monitoring circuitry and/or charging circuitry via wireless or wired communication. In some cases, control circuitry may be configured to store identified parameter values on a remote server, and in some cases, control circuitry algorithms may be updated by a user.

Control circuitry may perform or execute one or more applications, routines, programs and/or data structures that implement particular methods, techniques, tasks or operations described and illustrated herein. The functionality of the applications, routines or programs may be combined or distributed. In addition, the applications, routines or programs may be implementing by control circuitry using any programming language whether now known or later developed, including, for example, assembly, FORTRAN, C, C++, and BASIC, whether compiled or uncompiled code; all of which are intended to fall within the scope of the present disclosure.

### Example Embodiments:

Embodiment 1: A method comprising: (a) collecting a multi-dimensional set of battery parameters associated with a rechargeable battery; (b) generating a multi-dimensional set of predicted future state of performance values of the rechargeable battery based on the multi-dimensional set of battery parameters; and (c) performing at least one of: (1) identification of a future use pattern of the rechargeable battery based at least in part on the multi-dimensional set of predicted future state of performance values; (2) presentation of an alert indicating a predicted future performance of the rechargeable battery; or (3) identification of a future use pattern of a system to which the rechargeable battery provides power and/or electrical energy based at least in part on the multi-dimensional set of predicted future state of performance values.

Embodiment 2: The method of embodiment 1, wherein the rechargeable battery comprises a battery pack comprised of a plurality of battery cells, or a battery module comprised of a plurality of battery packs.

Embodiment 3: The method of embodiment 2, further comprising characterizing states of the plurality of battery cells within the battery pack.

Embodiment 4: The method of any one of embodiments 1-3, wherein the predicted future state of performance values comprise values represented of a predicted future health of the rechargeable battery.

Embodiment 5: The method of any one of embodiments 1-4, wherein the multi-dimensional set of battery parameters comprise at least one change in a battery parameter, or one rate of change in a battery parameter.

Embodiment 6: The method of any one of embodiments 1-5, wherein the multi-dimensional set of battery parameters comprise at least one of: an open circuit voltage of the rechargeable battery, a loaded circuit voltage of the rechargeable battery, a charge pulse voltage of the rechargeable battery, electrochemical impedance spectroscopy (EIS) information associated with the rechargeable battery, a capacity of the rechargeable battery, impedance information associated with the rechargeable battery, an overpotential, a relaxation time, an estimate of anode potential, a current associated with the rechargeable battery, a temperature of the rechargeable battery, a state of charge (SOC) of the rechargeable battery, a state of safety of the rechargeable battery, a state of health (SOH) of the rechargeable battery, derivatives with respect to time of one or more measured battery parameters, or gradients with respect to a spatial region of one or more measured battery parameters.

Embodiment 7: The method of any one of embodiments 1-6, wherein the multi-dimensional set of battery parameters comprise at least one battery parameter that is a result of applying at least one measured battery parameter to one or more functions, machine learning algorithms, or filtering algorithms.

Embodiment 8: The method of claim 7, wherein the filtering algorithm comprises a recursive estimation algorithm.

Embodiment 9: The method of embodiment 8, wherein the one or more functions, machine learning algorithms, or filtering algorithms are configured to detect a trend in the at least one measured battery parameter.

Embodiment 10: The method of any one of embodiments 8-9, wherein the one or more functions, machine learning algorithms, or filtering algorithms are configured to generate a prediction of at least one of: degradation of properties or functions of the rechargeable battery, degradation of structural materials within the rechargeable battery, thickening or growth of an SEI layer of the rechargeable battery; a lithium inventory of the rechargeable battery, lithium plating associated with the rechargeable battery, swelling of the rechargeable battery, or an evolution of swelling or lithium plating associated with the rechargeable battery over time.

Embodiment 11: The method of embodiment 10, wherein the prediction of evolution of swelling or lithium plating associated with the rechargeable battery over time is over a period of time greater than at least two days.

Embodiment 12: The method of any one of embodiments 10 or 11, where the prediction of evolution of swelling or lithium plating associated with the rechargeable battery over time is over a period of time greater than at least about two weeks.

Embodiment 13: The method of any one of embodiments 1-12, wherein the multi-dimensional set of predicted future state of performance values comprises at least one of: an indication of a state of power (SOP) of the rechargeable battery at a future time point, an indication of a state of energy (SOE) of the rechargeable battery at the future time point, a state of health (SOH) of the rechargeable battery at the future time, or one or more temperatures or temperature gradients associated with the rechargeable battery.

Embodiment 14: The method of embodiment 13, wherein the rechargeable battery comprises a battery pack, and wherein the one or more temperature gradients comprise gradients across cells of the battery pack.

Embodiment 15: The method of any one of embodiments 1-14, wherein the system to which the rechargeable battery provides power and/or electrical energy is a vehicle, a consumer device, a flight machine or an airplane, a stationary energy-storage system, or a stationary or mobile charging station.

Embodiment 16: The method of embodiment 15, wherein the vehicle is at least one of: a two-wheel vehicle, a four-wheel vehicle, a commercial delivery truck, or a truck.

Embodiment 17: The method of any one of embodiments 1-16, wherein the multi-dimensional set of predicted state of future performance values comprises at least one of: an indication of the remaining useful life of the rechargeable battery, a safety risk associated with the rechargeable battery, or a distance a vehicle, powered by the rechargeable battery, can travel using the rechargeable battery.

Embodiment 18: The method of any one of embodiments 1-17, wherein a first dimension of the multi-dimensional set of predicted future state of performance values corresponds to multiple time points at which future state of performance values are predicted.

Embodiment 19: The method of any one of embodiments 1-18, wherein a given predicted future state of performance value of the multi-dimensional set of predicted future state of performance values is associated with a confidence level, and wherein (c) is performed based at least in part on the confidence level.

Embodiment 20: The method of any one of embodiments 1-19, further comprising, prior to (c), determining a difference between at least one predicted future state of performance value from the multi-dimensional set of predicted future state of performance values to a target value, wherein (c) is performed based at least in part on the difference.

Embodiment 21: The method of embodiment 20, wherein the at least one predicted future state of performance value comprises a predicted remaining useful life of the rechargeable battery, and wherein the target value comprises a target remaining useful life of the rechargeable battery.

Embodiment 22: The method of any one of embodiments 20 or 21, wherein parameters used in (c) to modify the use pattern of the rechargeable battery and/or modify the use pattern of the system to which the rechargeable battery provides power are selected as parameters likely to change the at least one predicted future state of performance value toward the target value.

Embodiment 23: The method of embodiment 22, wherein the use pattern of the system and/or the use pattern of the rechargeable battery comprises a charging profile and/or limits on a discharge profile.

Embodiment 24: The method of any one of embodiments 1-23, wherein (a)-(c) occur during use of the system to which the rechargeable battery supplies power.

Embodiment 25: The method of any one of embodiments 1-24, wherein the system comprises a vehicle or a vessel.

Embodiment 26: The method of embodiment 25, wherein modification of the use pattern of the system to which the rechargeable battery provides power comprises modifying a route of the vehicle based at least in part on the predicted future performance of the rechargeable battery.

Embodiment 27: The method of embodiment 26, wherein modifying the route of the vehicle comprises selecting a route based on a terrain of the route.

Embodiment 28: The method of any one of embodiments 25-27, wherein modification of the use pattern of the system to which the rechargeable battery provides power comprises limiting a speed of the vehicle.

Embodiment 29: The method of any one of embodiments 25-28, wherein the system to which the rechargeable battery provides power and/or electrical energy is an energy storage system or a charging station, and wherein modification of the use pattern of the device comprises limiting a peak power supplied by the energy storage system or the charging station.

Embodiment 30: The method of any one of embodiments 1-29, wherein modification of the use pattern of the rechargeable battery comprises modifying a charging process of the rechargeable battery and/or modifying a discharge process of the rechargeable battery.

Embodiment 31: The method of embodiment 30, wherein modifying the charging process comprises at least one of: reducing a charge rate, reducing a charging voltage, or reducing a charging current.

Embodiment 32: The method of any one of embodiments 30 or 31, wherein modifying the discharge process comprises at least one of: reducing a depth of discharge, applying limits of the rechargeable battery's maximum power output; or modifying a temperature of the rechargeable battery.

Embodiment 33: The method of any one of embodiments 1-32, wherein presentation of the alert comprises presenting an indication that the rechargeable battery is to be replaced.

Embodiment 34: The method of any one of embodiments 1-33, wherein the system to which the rechargeable battery provides power is a second device to which the rechargeable battery provides power after having provided power to a different, first device.

Embodiment 35: The method of any one of embodiments 1-34, further comprising applying (a) - (c) to a battery pack comprising a plurality of rechargeable battery cells operatively coupled.

Embodiment 36: The method of any one of embodiments 1-35, wherein (b) and/or (c) are performed using one or more machine learning models.

Embodiment 37: The method of embodiment 36, wherein (b) and/or (c) are performed by combining output of a physical model and the one or more machine learning models.

Embodiment 38: The method of embodiment 37, wherein combining the output of the physical model and the one or more machine learning models comprises generating a first set of predictions using the physical model and a second set of predictions using the one or more machine learning models and aggregating the first set of predictions and the second set of predictions to generate an aggregate prediction associated with the rechargeable battery.

Embodiment 39: A method comprising: (a) collecting a multi-dimensional set of battery parameters associated with a rechargeable battery, wherein the multi-dimensional set of battery parameters comprise values of a set of battery parameters at a plurality of timepoints; and (b) predicting a future performance metric of the rechargeable battery based at least in part on the multi-dimensional set of battery parameters, the future performance metric representing estimates of one or more of: state of power, state of energy, state of capacity, remaining useful life, or state of health at one or more future times.

Embodiment 40: The method of embodiment 39, wherein the plurality of timepoints correspond to a sampling of battery parameters of the set of battery parameters at a sampling frequency greater than about 10 Hz.

Embodiment 41: The method of any one of embodiments 39 or 40, wherein the plurality of timepoints correspond to a sampling of battery parameters of the set of battery parameters at a sampling frequency greater than about 200 Hz.

Embodiment 42: The method of any one of embodiments 39-41, wherein the one or more future times include at least one future time greater than 1 month in the future.

Embodiment 43: The method of any one of embodiments 39-42, wherein the one or more future times comprise at least one future time greater than about 200 charging cycles of the rechargeable battery or greater than a duration of time corresponding to about 200 charging cycles.

Embodiment 44: The method of any one of embodiments 39-43, wherein the future performance metric comprises a multi-dimensional set of future performance metrics.

Embodiment 45: The method of embodiment 44, wherein the multi-dimensional set of future performance metrics comprise a plurality of future performance metrics at a plurality of future times.

Embodiment 46: The method of any one of embodiments 39-45, wherein the future performance metric is predicted based on an expected future use pattern of the rechargeable battery, wherein the expected future use pattern considers at least one of: a temperature profile of the rechargeable battery, a temperature gradient across cells of a battery pack corresponding to the rechargeable battery, a discharge current of the rechargeable battery, a power output of the rechargeable battery, or a device the rechargeable battery will be used to power.

Embodiment 47: The method of any one of embodiments 39-46, wherein the multi-dimensional set of battery parameters comprise at least one of: an open circuit voltage of the rechargeable battery, a loaded circuit voltage of the rechargeable battery, a charge pulse voltage of the rechargeable battery, electrochemical impedance spectroscopy (EIS) information associated with the rechargeable battery, a capacity of the rechargeable battery, impedance information associated with the rechargeable battery, a current associated with the rechargeable battery, or a state of health (SOH) of the rechargeable battery.

Embodiment 48: A method for optimizing routes of vehicles, the method comprising: obtaining, for a given vehicle powered by a rechargeable battery pack, a set of candidate routes from an initial location to a destination; determining, for each candidate route, a minimum peak power requirement to traverse the candidate route; discarding candidate routes from the set of candidate routes having a minimum peak power requirement exceeding a peak power available from the rechargeable battery pack; for each remaining route of the set of candidate routes, determining an amount of energy required to traverse the candidate route; and selecting a route from the set of candidate routes based on the amount of energy required and an energy available from the rechargeable battery pack.

Embodiment 49: The method of embodiment 48, wherein determining the minimum peak power requirement for a given candidate route comprises performing a simulation of the vehicle traversing the given candidate route.

Embodiment 50: The method of any one of embodiment 48 or 49, wherein the simulation considers at least one of: a terrain of the given candidate route, traffic along the given candidate route, speed limits along the given candidate route, a gross vehicle weight, weather conditions along the given candidate route, and drive-train characteristics of the vehicle.

Embodiment 51: The method of any one of embodiments 48-50, wherein selecting the route is further based on an estimated time to traverse the selected route.

Embodiment 52: The method of any one of embodiments 48-51, wherein the selected route is applicable to a traversal from the initial location to the destination at a future time corresponding to at least about 20 charging cycles in the future.

Embodiment 53: The method of embodiment 52, wherein the future time corresponds to at least about 100 charging cycles in the future.

## Claims

1. A method comprising:
(a) collecting a multi-dimensional set of battery parameters associated with a rechargeable battery;
(b) generating a multi-dimensional set of predicted future state of performance values of the rechargeable battery based on the multi-dimensional set of battery parameters; and
(c) performing at least one of: (1) identification of a future use pattern of the rechargeable battery based at least in part on the multi-dimensional set of predicted future state of performance values; (2) presentation of an alert indicating a predicted future performance of the rechargeable battery; or (3) identification of a future use pattern of a system to which the rechargeable battery provides power and/or electrical energy based at least in part on the multi-dimensional set of predicted future state of performance values.

2. The method of claim 1, wherein the rechargeable battery comprises a battery pack comprised of a plurality of battery cells, or a battery module comprised of a plurality of battery packs, optionally further comprising characterizing states of the plurality of battery cells within the battery pack.

3. The method of any one of claims 1-2, wherein the predicted future state of performance values comprise values represented of a predicted future health of the rechargeable battery.

4. The method of any one of claims 1-3, wherein the multi-dimensional set of battery parameters comprise: (i) at least one change in a battery parameter, or one rate of change in a battery parameter; (ii) at least one of: an open circuit voltage of the rechargeable battery, a loaded circuit voltage of the rechargeable battery, a charge pulse voltage of the rechargeable battery, electrochemical impedance spectroscopy (EIS) information associated with the rechargeable battery, a capacity of the rechargeable battery, impedance information associated with the rechargeable battery, an overpotential, a relaxation time, an estimate of anode potential, a current associated with the rechargeable battery, a temperature of the rechargeable battery, a state of charge (SOC) of the rechargeable battery, a state of safety of the rechargeable battery, a state of health (SOH) of the rechargeable battery, derivatives with respect to time of one or more measured battery parameters, or gradients with respect to a spatial region of one or more measured battery parameters; or (iii) at least one battery parameter that is a result of applying at least one measured battery parameter to one or more functions, machine learning algorithms, or filtering algorithms.

5. The method of claim 4, part (iii), wherein: (i) the filtering algorithm comprises a recursive estimation algorithm; or (ii) the one or more functions, machine learning algorithms, or filtering algorithms are configured to detect a trend in the at least one measured battery parameter; or (iii) the one or more functions, machine learning algorithms, or filtering algorithms are configured to generate a prediction of at least one of: degradation of properties or functions of the rechargeable battery, degradation of structural materials within the rechargeable battery, thickening or growth of an SEI layer of the rechargeable battery; a lithium inventory of the rechargeable battery, lithium plating associated with the rechargeable battery, swelling of the rechargeable battery, or an evolution of swelling or lithium plating associated with the rechargeable battery over time.

6. The method of claim 5, wherein the prediction of evolution of swelling or lithium plating associated with the rechargeable battery over time is over a period of time greater than at least two days, for example, greater than at least about 2 weeks.

7. The method of any one of claims 1-6, wherein the multi-dimensional set of predicted future state of performance values comprises at least one of: an indication of a state of power (SOP) of the rechargeable battery at a future time point, an indication of a state of energy (SOE) of the rechargeable battery at the future time point, a state of health (SOH) of the rechargeable battery at the future time, or one or more temperatures or temperature gradients associated with the rechargeable battery, optionally wherein the rechargeable battery comprises a battery pack, and wherein the one or more temperature gradients comprise gradients across cells of the battery pack.

8. The method of any one of claims 1-7, wherein the system to which the rechargeable battery provides power and/or electrical energy is a vehicle, a consumer device, a flight machine or an airplane, a stationary energy-storage system, or a stationary or mobile charging station, optionally wherein the vehicle is at least one of: a two-wheel vehicle, a four-wheel vehicle, a commercial delivery truck, or a truck.

9. The method of any one of claims 1-8 wherein: (i) the multi-dimensional set of predicted state of future performance values comprises at least one of: an indication of the remaining useful life of the rechargeable battery, a safety risk associated with the rechargeable battery, or a distance a vehicle, powered by the rechargeable battery, can travel using the rechargeable battery; and/or (ii) a first dimension of the multi-dimensional set of predicted future state of performance values corresponds to multiple time points at which future state of performance values are predicted; and/or (iii) a given predicted future state of performance value of the multi-dimensional set of predicted future state of performance values is associated with a confidence level, and wherein (c) is performed based at least in part on the confidence level.

10. The method of any one of claims 1-9, further comprising, prior to (c), determining a difference between at least one predicted future state of performance value from the multi-dimensional set of predicted future state of performance values to a target value, wherein (c) is performed based at least in part on the difference, optionally wherein: (i) the at least one predicted future state of performance value comprises a predicted remaining useful life of the rechargeable battery, and wherein the target value comprises a target remaining useful life of the rechargeable battery; and/or (ii) parameters used in (c) to modify the use pattern of the rechargeable battery and/or modify the use pattern of the system to which the rechargeable battery provides power are selected as parameters likely to change the at least one predicted future state of performance value toward the target value, optionally wherein the use pattern of the system and/or the use pattern of the rechargeable battery comprises a charging profile and/or limits on a discharge profile.

11. The method of any one of claims 1-10, wherein: (i) (a)-(c) occur during use of the system to which the rechargeable battery supplies power; or (ii) the system comprises a vehicle or a vessel, optionally wherein modification of the use pattern of the system to which the rechargeable battery provides power comprises modifying a route of the vehicle based at least in part on the predicted future performance of the rechargeable battery, further optionally wherein modification of the use pattern of the system to which the rechargeable battery provides power comprises modifying a route of the vehicle based at least in part on the predicted future performance of the rechargeable battery, further optionally wherein modifying the route of the vehicle comprises selecting a route based on a terrain of the route, further optionally wherein modification of the use pattern of the system to which the rechargeable battery provides power comprises limiting a speed of the vehicle; or (iii) the system to which the rechargeable battery provides power and/or electrical energy is an energy storage system or a charging station, and wherein modification of the use pattern of the device comprises limiting a peak power supplied by the energy storage system or the charging station.

12. The method of any one of claims 1-11, wherein modification of the use pattern of the rechargeable battery comprises modifying a charging process of the rechargeable battery and/or modifying a discharge process of the rechargeable battery, optionally wherein: (i) modifying the charging process comprises at least one of: reducing a charge rate, reducing a charging voltage, or reducing a charging current; or (ii) modifying the discharge process comprises at least one of: reducing a depth of discharge, applying limits of the rechargeable battery's maximum power output; or modifying a temperature of the rechargeable battery.

13. The method of any one of claims 1-12, wherein presentation of the alert comprises presenting an indication that the rechargeable battery is to be replaced.

14. The method of any one of claims 1-13, wherein the system to which the rechargeable battery provides power is a second device to which the rechargeable battery provides power after having provided power to a different, first device.

15. The method of any one of claims 1-14, further comprising applying (a) - (c) to a battery pack comprising a plurality of rechargeable battery cells operatively coupled, or wherein (b) and/or (c) are performed using one or more machine learning models, optionally wherein (b) and/or (c) are performed by combining output of a physical model and the one or more machine learning models, further optionally wherein combining the output of the physical model and the one or more machine learning models comprises generating a first set of predictions using the physical model and a second set of predictions using the one or more machine learning models and aggregating the first set of predictions and the second set of predictions to generate an aggregate prediction associated with the rechargeable battery.
